# EUROPÄISCHE PATENTSCHRIFT

(11) **EP 4 598 397 B1**
(45) Veröffentlichungstag und Bekanntmachung des Hinweises auf die Patenterteilung: **08.04.2026**
(21) Anmeldenummer: 23821119.7
(22) Anmeldetag: 01.12.2023
(51) Int. Cl.: A47B 88/457

(54) **ANORDNUNG UMFASSEND EIN FESTSTEHENDES MÖBELTEIL, EIN BEWEGBARES MÖBELTEIL, EINE FÜHRUNGSVORRICHTUNG UND EINE ELEKTRISCHE ANTRIEBSVORRICHTUNG**
ASSEMBLY COMPRISING A FIXED FURNITURE PART, A MOVING FURNITURE PART, A GUIDE DEVICE AND AN ELECTRICAL DRIVE DEVICE
ENSEMBLE COMPRENANT UNE PARTIE MEUBLE FIXE, UNE PARTIE MEUBLE MOBILE, UN DISPOSITIF DE GUIDAGE ET UN DISPOSITIF D'ENTRAÎNEMENT ÉLECTRIQUE

(30) Priorität: 23.12.2022 AT 509962022
(43) Veröffentlichungstag der Anmeldung: 13.08.2025
(73) Patentinhaber: JULIUS BLUM GMBH, 6973 Höchst (AT)
(72) Erfinder: PETERLUNGER, Alexander, 6890 Lustenau (AT); GASSER, Björn, 6881 Mellau (AT)
(74) Vertreter: Torggler & Hofmann Patentanwälte - Innsbruck
(86) Internationale Anmeldenummer: PCT/AT2023/060419
(87) Internationale Veröffentlichungsnummer: WO 2024/130278

(56) Entgegenhaltungen:
- EP-A1- 1 323 364
- CN-U- 216 651 777

## Beschreibung

Die Erfindung betrifft eine Anordnung umfassend ein feststehendes Möbelteil, insbesondere Möbelkorpus, ein relativ zu dem feststehenden Möbelteil bewegbares Möbelteil, insbesondere Schublade, eine Führungsvorrichtung, insbesondere Schubladenausziehführung, zur Führung des bewegbaren Möbelteiles relativ zu dem feststehenden Möbelteil, mit wenigstens einer Korpusschiene und wenigstens einer relativ zu der wenigstens einen Korpusschiene verschiebbaren Ladenschiene und wenigstens eine elektrische Antriebsvorrichtung zur zumindest bereichsweise automatisierten Bewegung des bewegbaren Möbelteiles relativ zu dem feststehenden Möbelteil umfassend einen, insbesondere mit 230 V versorgbaren, Elektromotor.

Eine Anordnung mit einem bewegbaren Möbelteil ist bereits aus der Schrift EP 1 323 364 A1 bekannt, in welcher eine Schublade mittels einer über eine Auslöseeinrichtung angesteuerten Antriebseinheit bewegt wird. Die Auslöseeinrichtung umfasst hierzu zwei an der Schublade angeordnete sowie manuell betätigbare Tastschalter - beispielsweise einen Schleppschalter - für drei verschiedene Schaltzustände. Die Auslöseeinrichtung kann in Abhängigkeit einer Relativstellung von Möbelteilkomponenten oder über Antippen einer Möbelteilkomponente initiiert werden, um einen Schaltimpuls zu generieren.

Eine Anordnung mit einem bewegbaren Möbelteil ist auch bereits aus der Schrift EP 1 323 363 A1 bekannt, in welcher eine Antriebseinheit durch eine Regeleinrichtung sowie über eine Kraftmesseinrichtung angesteuert wird, um eine vom Benutzer einer Schublade gewünschte Bewegung automatisch bidirektional zu unterstützen. In Ergänzung kann eine Positionsmesseinrichtung vorhanden sein, welches ein Positionssignal erzeugt, mittels welcher eine momentane Istposition, Istgeschwindigkeit und Istbeschleunigung als Funktion der gemessenen Position berechnet werden kann. Sollwerte können ebenfalls ermittelt werden, sodass im Wesentlichen selbiger Kraftaufwand bei variierenden Beladungen der Schublade generiert werden kann.

Eine Anordnung mit einem bewegbaren Möbelteil ist auch bereits aus der Schrift EP 2 642 899 A1 bekannt, in welcher über zwei Sensoren unterschiedliche Auslösesensibilitäten bei Kraftausübung auf eine Schublade generiert werden können.

Eine weitere Anordnung mit einem bewegbaren Möbelteil ist bereits aus der Schrift CN 216 651 777 U bekannt.

Nachteilig am Stand der Technik ist, dass eine Überlastkupplung in der Antriebsvorrichtung integriert werden muss, um eine sachgemäße Funktionalität der Antriebsvorrichtung bei Erschütterungen oder starken Krafteinwirkungen auf das bewegbare Möbelteil kompensieren zu können.

Die objektive technische Aufgabe der vorliegenden Erfindung besteht daher darin, eine gegenüber dem Stand der Technik verbesserte Anordnung anzugeben, bei welcher die Nachteile des Standes der Technik zumindest teilweise behoben sind, und welche sich insbesondere durch eine besonders vorteilhafte Kompensation von externen Krafteinflüssen auf die Anordnung auszeichnet.

Es ist demnach erfindungsgemäß vorgesehen, dass wenigstens eine Zuzieheinrichtung für das bewegbare Möbelteil und wenigstens eine in Wirkverbindung mit der wenigstens einen elektrischen Antriebsvorrichtung stehende Zahnstange vorgesehen sind, wobei die wenigstens eine Zuzieheinrichtung, vorzugsweise unmittelbar, an der wenigstens einen Ladenschiene angeordnet ist und die wenigstens eine Zahnstange, vorzugsweise mittelbar, an der wenigstens einen Ladenschiene angeordnet ist, wobei die wenigstens eine Zahnstange lösbar an wenigstens einer Trägereinrichtung angeordnet ist und/oder die wenigstens eine Trägereinrichtung lösbar an der wenigstens einen Zuzieheinrichtung angeordnet ist.

Dadurch wird es erst ermöglicht, dass über die lösbare Verbindung - insbesondere die doppelte lösbare Verbindung - über die beteiligten Bauteilkomponenten eine Überlastkupplung konstituiert werden kann, wodurch auf eine Überlastkupplung der elektrischen Antriebseinheit 6 verzichtet werden kann.

Beispielsweise kann durch eine im Belastungsfall dadurch bedingte Toleranz in der Interaktion zwischen einem Zahnrad der elektrischen Antriebsvorrichtung und der Zahnstange unter erhöhter Belastung der Zahnstange (beispielsweise bei Erschütterungen oder unsachgemäßen Krafteinwirkungen auf das bewegbare Möbelteil) verhindert werden, dass eine vollständige Entkoppelung zwischen der elektrischen Antriebsvorrichtung und der Zahnstange erfolgt - ohne die Wirkung einer Überlastkupplung zu verlieren, wodurch die Position der Ladenschiene relativ zu der Korpusschiene eindeutig über die relative Stellung zwischen der Zahnstange und dem Zahnrad bestimmbar bleibt.

Eine Entkopplung zum Elektromotor ist nicht erforderlich und kann beispielsweise über eine Freilaufkupplung generiert werden. Eine erforderliche Referenzfahrt kann unterbunden werden, wobei die Trägereinrichtung als Koppeleinrichtung agieren kann.

Vorteilhafte Ausführungsformen der Erfindung sind in den abhängigen Ansprüchen definiert.

Weitere Einzelheiten und Vorteile der vorliegenden Erfindung werden anhand der Figurenbeschreibung unter Bezugnahme auf die in den Zeichnungen dargestellten Ausführungsbeispiele im Folgenden näher erläutert. Darin zeigen:
- Fig. 1a, 1b: eine durch eine elektrische Antriebsvorrichtung gemäß einer bevorzugten Ausführungsform angetriebene Führungsvorrichtung eines Möbels in einer perspektivischen Ansicht mit einer vergrößerten Detaildarstellung im Bereich der elektrischen Antriebsvorrichtung,
- Fig. 2-4: die Führungsvorrichtung gemäß dem Ausführungsbeispiel nach Fig. 1b in perspektivischer Ansicht mit vergrößerter Detaildarstellungen im Bereich einer Anbindung einer Zahnstange an einer Ladenschiene,
- Fig. 5: die Führungsvorrichtung gemäß dem Ausführungsbeispiel nach Fig. 1b in einer Ansicht von oben mit vergrößerter Detaildarstellung im Bereich einer Kopplung zwischen der Zahnstange und einem Zahnrad der elektrischen Antriebsvorrichtung,
- Fig. 6: die Führungsvorrichtung gemäß dem Ausführungsbeispiel nach Fig. 1b in einer Ansicht von unten mit vergrößerter Detaildarstellung im Bereich einer Anbindung der elektrischen Antriebsvorrichtung an einer Korpusschiene,
- Fig. 7a, 7b: die elektrische Antriebsvorrichtung gemäß dem Ausführungsbeispiel nach Fig. 1b mit einem Träger für die Kopplung mit der Korpusschiene in einer Ansicht von oben und einer perspektivischen Ansicht,
- Fig. 8a, 8b: die elektrischen Antriebsvorrichtung gemäß dem Ausführungsbeispiel nach Fig. 1b mit demontiertem Gehäuse in zwei perspektivischen Ansichten von einer Vorderseite und einer Rückseite,
- Fig. 9, 10: eine Wegmesseinrichtung der elektrischen Antriebsvorrichtung gemäß dem Ausführungsbeispiel nach Fig. 1b in Explosionsdarstellung sowie in einer Ansicht von oben mit vergrößerter Detaildarstellung im Bereich von Positionssensoren,
- Fig. 11, 12: die elektrische Antriebsvorrichtung gemäß Fig. 8a in perspektivischer Ansicht mit vergrößerter Detaildarstellung im Bereich eines Schutzkörpers im Gehäuse zum Schutz eines Getriebes vor Abrieb von einem Riemen sowie eines Riemenantriebes mit beidseitigen Riemenspannern,
- Fig. 13a, 13b: eine Getriebeanordnung der elektrischen Antriebsvorrichtung gemäß der Ausführungsform nach Fig. 1b in zwei perspektivischen Darstellungen,
- Fig. 14a, 14b: eine Freilaufkupplung der elektrischen Antriebsvorrichtung gemäß der Ausführungsform nach Fig. 1b in einer Draufsicht und einer perspektivischen Ansicht,
- Fig. 15: eine Führungsvorrichtung gemäß einer weiteren bevorzugten Ausführungsform mit einer einseitig angeordneten elektrischen Antriebsvorrichtung in perspektivischer Ansicht,
- Fig. 16: ein Diagramm zur Veranschaulichung einer eindeutigen Positionsmessung beziehungsweise Absolutwegmessung für ein bewegbares Möbelteil entlang einer Führungsvorrichtung durch eine Wegmesseinrichtung gemäß der Ausführungsform nach Fig. 9 via Sensorwinkel über Auszugslängen.

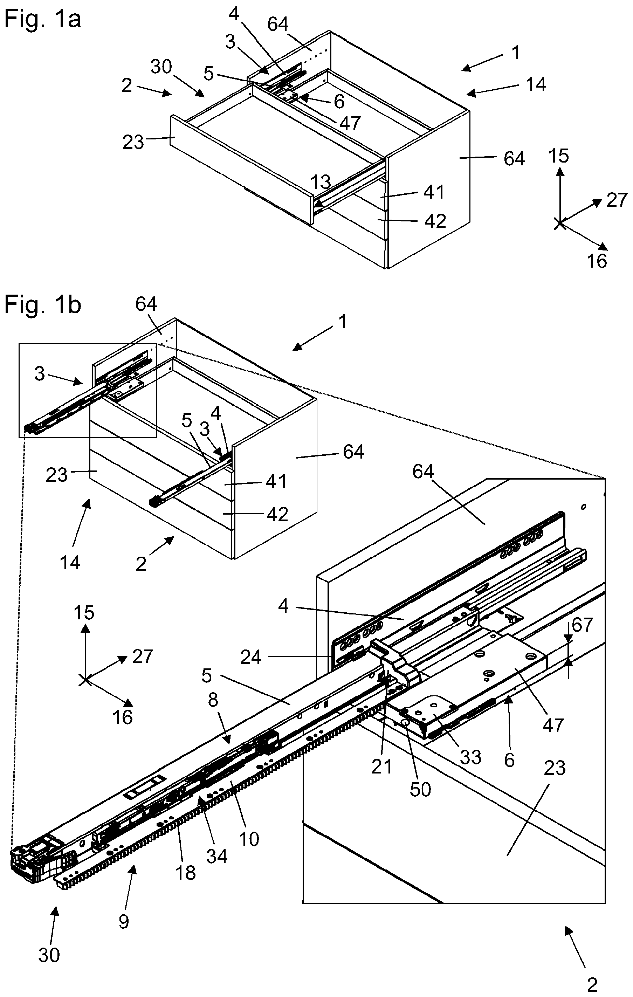

Fig. 1a zeigt ein Möbel mit bewegbaren Möbelteilen 2 in Form von Schubladen, welche relativ zu einem feststehenden Möbelteil 1 in Form eines Möbelkorpus über eine Führungsvorrichtung 3 in Form einer Schubladenausziehführung durch eine elektrische Antriebsvorrichtung 6 bewegt werden können.

Die bewegbaren Möbelteile 2 können in ein erstes bewegbares Möbelteil 41 und weitere bewegbare Möbelteile 42 gegliedert werden, wobei die weiteren bewegbaren Möbelteile 42 in Gebrauchsstellung 14 der Anordnung unterhalb des ersten bewegbaren Möbelteiles 41 angeordnet sind.

Das Möbel ist jedoch nicht auf Schubladen beschränkt und kann im Allgemeinen anderweitige Behältnisse umfassen. Beispielsweise kann das Möbel als Möbelkorpus mit einer Klappe, einem Schrank mit einer Falt- und/oder Schiebetür oder dergleichen vorliegen.

Fig. 1b zeigt das Möbel mit einem ausgeblendeten bewegbaren Möbelteil 2 in einer Anordnung umfassend das feststehende Möbelteil 1, das relativ zu dem feststehenden Möbelteil 1 bewegbare Möbelteil 2 und zwei Führungsvorrichtung 3 zur Führung des bewegbaren Möbelteiles 2 relativ zu dem feststehenden Möbelteil 1.

Die Anordnung umfasst eine elektrische Antriebsvorrichtung 6 zur zumindest bereichsweise automatisierten Bewegung des bewegbaren Möbelteiles 2 relativ zu dem feststehenden Möbelteil 1 umfassend einen mit 230 V versorgbaren Elektromotor 7. Die Energiebereitstellung für den Elektromotor 7 ist im Allgemeinen beliebig und kann auch mit abweichenden Spannungen betrieben werden. Im Allgemeinen kann eine Spannung auch - insbesondere durch lokale oder regionale Stromnetzcharakteristika - niedriger sein, um den Elektromotor 7 mit hinreichender Energie zu versorgen.

Die Führungsvorrichtungen 3 umfassen jeweils eine an dem feststehenden Möbelteil 1 angeordnete Korpusschiene 4 und eine an dem bewegbaren Möbelteil 2 angeordnete Ladenschiene 5. Im Allgemeinen kann eine Mittelschiene zumindest bereichsweise zwischen der Korpusschiene 4 und der Ladenschiene 5 angeordnet sein, dies ist im Allgemeinen jedoch - insbesondere auch für einen Vollauszug des bewegbaren Möbelteiles 2 durch die frontseitige Anordnung der elektrischen Antriebsvorrichtung 6 sowie der Anbindung an eine Zahnstange 9 - nicht erforderlich.

Im Detailausschnitt ist die Anbindung der elektrischen Antriebsvorrichtung 6 an der Korpusschiene 4 und einer Zahnstange 9 an der Ladenschiene 5 vergrößert dargestellt, wobei die Ladenschiene 5 eine erste Schnittstelle 34 (gegebenenfalls eine Vielzahl an ersten Schnittstellen 34) umfasst, welche dazu geeignet ist, eine Ausstoßeinrichtung 11 und eine Zuzieheinrichtung 8 an der Ladenschiene 5 zu fixieren.

An der ersten Schnittstelle 34 ist eine Zuzieheinrichtung 8 angeordnet, welche im Allgemeinen nicht erforderlich ist. Alternativ oder in Ergänzung kann an der ersten Schnittstelle 34 eine - insbesondere mechanische oder elektrische - Ausstoßeinrichtung 11 angeordnet sein. Bevorzugt umfasst die Ausstoßeinrichtung 11 eine Tip-On-Funktion, mit welcher ein Ausstoßprozess durch Überdrückbewegung ausgelöst werden kann.

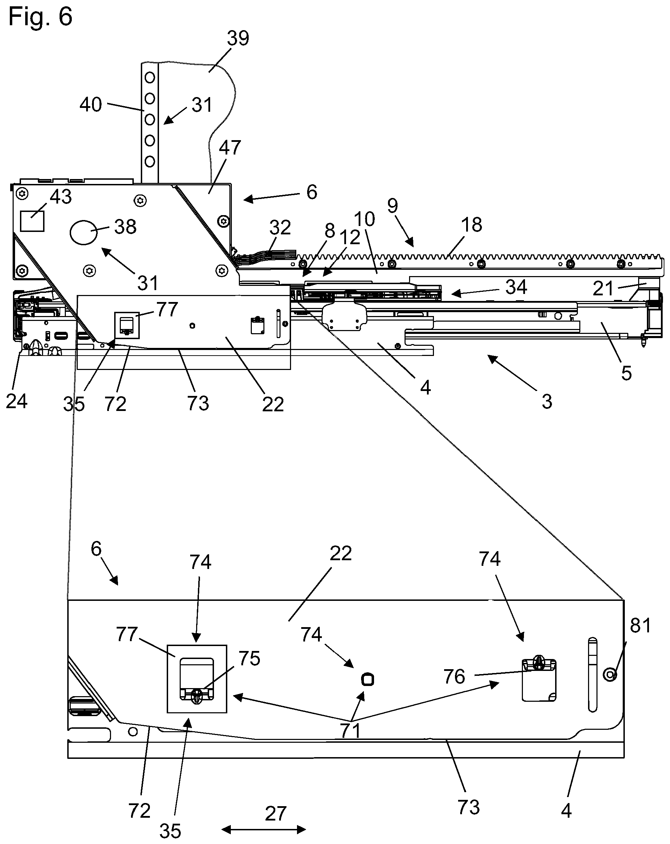

Die Korpusschiene 4 umfasst eine zweite Schnittstelle 35 (gegebenenfalls eine Vielzahl an zweiten Schnittstellen 35), welche dazu geeignet ist, einen Mitnehmer 36 für die Ausstoßeinrichtung 11 oder die Zuzieheinrichtung 8 an der Korpusschiene 4 zu fixieren. Die zweite Schnittstelle 35 befindet sich (in der Ansicht nicht sichtbar) an der Unterseite der Korpusschiene 4 (siehe Fig. 6).

Die elektrische Antriebsvorrichtung 6 ist an der zweiten Schnittstelle 35 angeordnet und die Zahnstange 9 zur Kraftübertragung von der elektrischen Antriebsvorrichtung 6 auf die Ladenschiene 5 an der ersten Schnittstelle 34 angeordnet.

Die Anbindung der elektrischen Antriebsvorrichtung 6 erfolgt über eine Clipverbindung 71 und über einen Einschwenkvorgang zum Einhängen (vgl. Fig. 6). Die Anbindung der Zahnstange 9 erfolgt über eine Clipverbindung 71 im Zuge eines translatorischen Einschiebevorganges in die Zuzieheinrichtung 8 oder die Ladenschiene 5. Beispielsweise kann die Clipverbindung 71 (an der Zahnstange 9, der Zuzieheinrichtung 8 oder der Ladenschiene 5) einen einrastbaren Steg oder einen Rastbuckel 81 aufweisen, wobei im Allgemeinen alternativ oder in Ergänzung auch Haken 75 möglich sind. Im Ausführungsbeispiel wird die Zahnstange 9 an der Zuzieheinrichtung 8 angebunden, welche gegebenenfalls eine Ausstoßeinrichtung 11 aufweisen kann oder an welcher gegebenenfalls eine Ausstoßeinrichtung 11 angebunden werden kann (ein Ersatz der Zuzieheinrichtung 8 ist ebenfalls denkbar). Eine direkte Anbindung der Zahnstange 9 an der Ladenschiene 5 ist ebenfalls möglich. Eine mittelbare Anbindung der elektrischen Antriebsvorrichtung 8 (beispielsweise über einen Mitnehmer 36 für die Zuzieheinrichtung 8) ist ebenfalls möglich, wobei eine direkte Verbindung bevorzugt ist.

Die Zahnstange 9 ist derart breit auszulegen, dass auch äquivalente Mittel wie ein Riemen (gegebenenfalls mit einer Verzahnung 18), ein Seil oder dergleichen zur Kraftvermittlung zwischen der elektrischen Antriebsvorrichtung 6 und der Ladenschiene 5 umfasst sind.

Die elektrische Antriebsvorrichtung 6 ist in Gebrauchsstellung 14 der Anordnung im Wesentlichen vollständig unterhalb des bewegbaren Möbelteiles 2 an der Korpusschiene 4 angeordnet, wobei gegebenenfalls eine Möbelteilfront 23 (beispielsweise zur Kontaktierung eines Auslösesensors 59) in vertikaler Richtung 15 unter eine Oberseite der elektrischen Antriebsvorrichtung 6 oder die elektrische Antriebsvorrichtung 6 ragen kann. Ein Boden des bewegbaren Möbelteiles 2 ist im Zuge der Bewegung des bewegbaren Möbelteiles vollständig oberhalb der elektrischen Antriebsvorrichtung angeordnet. Das bewegbare Möbelteil 2 überfährt die elektrische Antriebsvorrichtung 6 im Gebrauch.

Die elektrische Antriebsvorrichtung 6 ist stationär an der Korpusschiene 4 angeordnet und steht über eine gesamte Wegstrecke 13 für das bewegbare Möbelteil 2 entlang der Führungsvorrichtung 3 in stetiger Verbindung zu der Zahnstange 9 zur Bewegungsübertragung.

Das bewegbare Möbelteil 2 umfasst eine Möbelteilfront 23, wobei die elektrische Antriebsvorrichtung 6 an der Korpusschiene 4 in Gebrauchsstellung 14 der Anordnung im Bereich eines der Möbelteilfront 23 zugewandten freien Endes 24 der Korpusschiene 4 angeordnet ist.

Die elektrische Antriebsvorrichtung 6 ist in Schließstellung bündig zu der Ladenschiene 5 oder der Zahnstange 9 angeordnet. Durch die Zahnstange 9 kann ein Auszugsverlust - bedingt durch die Befestigung der Korpusschiene und/oder durch die Verwendung eines spezifischen Auslösesensortyps - kompensiert werden.

Die elektrische Antriebsvorrichtung 6 ist sowohl in Schließstellung als auch in Offenstellung 30 im Wesentlichen bündig zu dem freien Ende 24 der Korpusschiene 4 angeordnet.

Das feststehende Möbelteil 1 umfasst zwei in Gebrauchsstellung 14 vertikal und parallel zueinander orientierte Möbelplatten 64, wobei genau eine elektrische Antriebsvorrichtung 6 stationär an einer der beiden Möbelplatten 64 mittelbar über die Korpusschiene 4 angeordnet ist. Im Allgemeinen kann jedoch auch eine weitere elektrische Antriebsvorrichtung 6 oder eine zusätzliche Zahnstange 9 an der gegenüberliegenden Möbelplatte 64 angeordnet sein, wobei dies nicht zwingend erforderlich ist.

Das bewegbare Möbelteil 2 umfasst in Gebrauchsstellung 14 der Anordnung eine Möbelteilfront 23, wobei die elektrische Antriebsvorrichtung 6 an der Korpusschiene 4 im Bereich eines der Möbelteilfront 23 zugewandten freien Endes 24 der Korpusschiene 4 (im Wesentlichen bündig zu dem freien Ende 24 oder der Ladenschiene 5 in Schließstellung oder der Zahnstange 9 in Schließstellung) angeordnet.

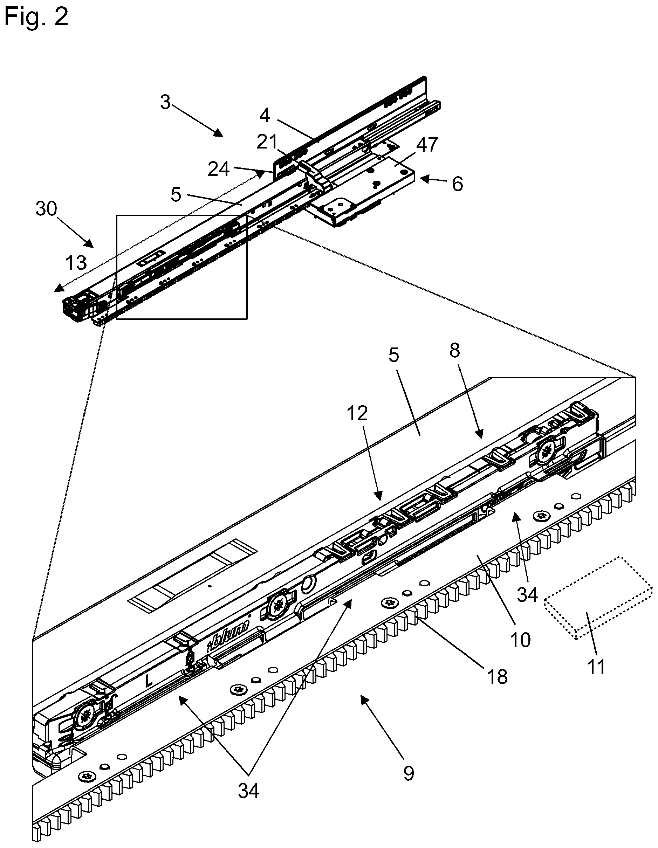

Fig. 2 zeigt die Anbindung der elektrischen Antriebsvorrichtung 6 an der Korpusschiene 4 ohne umliegende Möbelteile 1, 2, wobei die Ladenschiene 5 vollständig über die Wegstrecke 13 als Auszugsweg für das bewegbare Möbelteil 2 ausgefahren ist.

In dem vergrößerten Detailausschnitt ist die Anbindung der Zahnstange 9 an der Ladenschiene 5 beziehungsweise der Zuzieheinrichtung 8 ersichtlich, wobei in punktierter Linie eine Ausstoßeinrichtung 11 angedeutet ist, welche alternativ oder in Ergänzung an der ersten Schnittstelle 34 angeordnet werden kann. Es ist auch denkbar eine Verriegelungseinrichtung 69 zur Hemmung einer Bewegung des bewegbaren Möbelteiles 2 an der ersten Schnittstelle 34 vorzusehen. Eine Dämpfvorrichtung 12 ist in der Zuzieheinrichtung 8 integriert, wobei die Dämpfvorrichtung 12 auch als gesonderte Bauteilkomponente vorliegen kann.

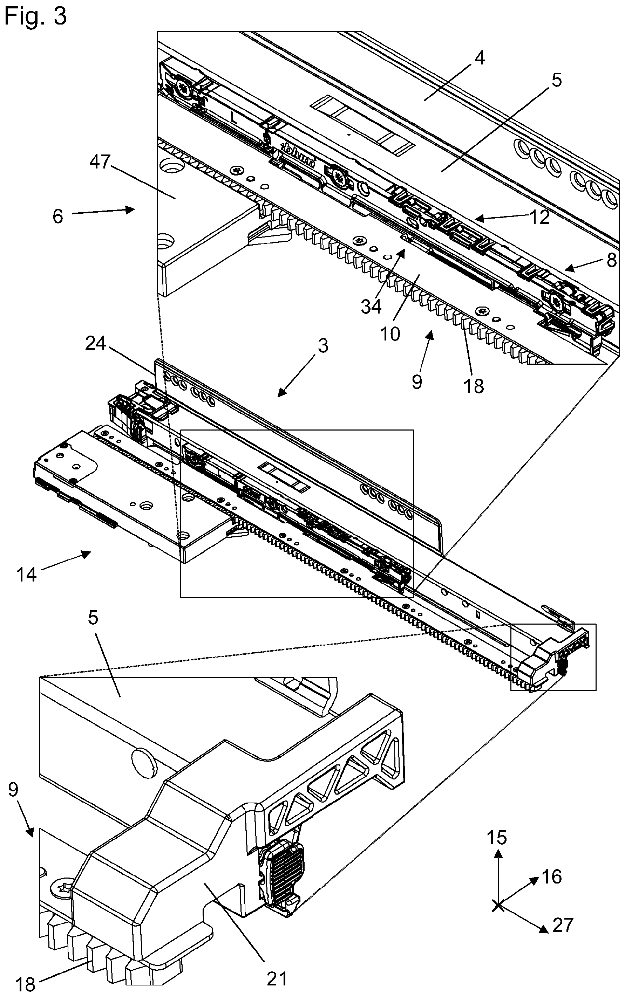

Fig. 3 zeigt die Führungsvorrichtung 3 mit der elektrischen Antriebsvorrichtung 6 zur automatisierten Bewegung des bewegbaren Möbelteiles 2 beziehungsweise der Ladenschiene 5 mit dem (mit 230 V versorgbaren) Elektromotor 7.

Die Zuzieheinrichtung 8 für das bewegbare Möbelteil 2 und die in Wirkverbindung mit der elektrischen Antriebsvorrichtung 6 stehende Zahnstange 9 sind montiert, wobei die Zuzieheinrichtung 8 unmittelbar an der Ladenschiene 5 angeordnet ist und die Zahnstange 9 mittelbar über die Zuzieheinrichtung 8 an der ersten Schnittstelle 34 der Ladenschiene 5 angeordnet ist. Im Allgemeinen kann die Zahnstange 9 alternativ oder in Ergänzung direkt die Ladenschiene 5 kontaktieren.

Die Zahnstange 9 ist lösbar an einer Trägereinrichtung 10 angeordnet und die Trägereinrichtung 10 ist lösbar an der Zuzieheinrichtung 8 angeordnet.

Die lösbare Verbindung der Trägereinrichtung 10 meint in diesem Kontext eine gewaltlos, vorzugsweise werkzeuglos, aufzuhebende Verbindung.

Die Trägervorrichtung 10 ist in horizontaler Richtung 16 zwischen der Zahnstange 9 und der Zuzieheinrichtung 8 angeordnet, wobei im Allgemeinen auch eine in vertikaler Richtung 15 nach unten weisende Zahnstange 9 vorgesehen sein kann.

Die Trägereinrichtung 10 oder die Zuzieheinrichtung 8 können eine mechanische oder elektrische Ausstoßeinrichtung 11 umfassen, wobei eine Dämpfvorrichtung 12 in der Zuzieheinrichtung 8 zur Dämpfung einer Bewegung des bewegbaren Möbelteiles 2 in einem Bereich der Schließstellung umfasst.

Die stationäre elektrische Antriebsvorrichtung 6 steht über die gesamte Wegstrecke 13 entlang der Führungsvorrichtung 3 in stetiger Verbindung zu der Zahnstange 9 zur Bewegungsübertragung, wobei der die elektrische Antriebsvorrichtung 6 ein mit der Zahnstange 9 kämmendes Zahnrad 17 in Verbindung mit dem Elektromotor 7 umfasst.

Die Zahnstange 9 ist über die gesamte Wegstrecke 13 seitlich zwischen der elektrischen Antriebsvorrichtung 6 und der Ladenschiene 5 angeordnet ist.

Bei diesem Ausführungsbeispiel ist genau eine elektrische Antriebsvorrichtung 6 an einer der beiden Korpusschienen 4 der Führungsvorrichtungen 3 und genau eine Zahnstange 9 an einer der beiden Ladenschienen 5 der Führungsvorrichtungen 3 vorgesehen, wobei im Allgemeinen auch zwei elektrische Antriebsvorrichtungen 6 an beiden Korpusschienen 4 genutzt werden können.

Eine Stromversorgung der elektrischen Antriebsvorrichtung 6 oder einer gegebenenfalls vorhandenen weiteren Stromsenke - wie dem Beleuchtungsmittel 31 in Fig. 6 - erfolgt über die Korpusschiene 4, wobei die Stromversorgung alternativ oder in Ergänzung über die Zahnstange 9 geführt sein kann. Die Stromversorgung kann zwischen den beiden Korpusschienen 4 der zwei vorgesehenen Führungsvorrichtungen 3 geführt sein, um beispielsweise einen weiteren Auslösesensor 65 mit Energie zu versorgen. Eine separate Stromversorgung pro Korpusschiene 4 (oder Zahnstange 9) ist ebenfalls möglich.

Eine Verzahnung 18 der Zahnstange 9 ist in Gebrauchsstellung 14 der Anordnung in horizontaler Richtung 16 in eine von der Ladenschiene 5 wegweisenden Richtung orientiert, wobei im Allgemeinen eine Ausrichtung in vertikaler Richtung 15 nach unten ebenfalls möglich ist.

Die Zahnstange 9 ist mit dem Zahnrad 17 der elektrischen Antriebsvorrichtung 6 gekoppelt, wobei die Zahnstange 9 (über eine Anbindung an der Trägereinrichtung 10 oder durch die Anbindung der Trägereinrichtung 10) in horizontaler Richtung 16 gegenüber der Ladenschiene 5 verbiegbar (verschwenkbar ist ebenfalls denkbar) und damit begrenzt seitlich bewegblich gelagert ist. Beispielsweise könnte die Zahnstange 9 auch bei einer vertikalen Verzahnung 18 in vertikaler Richtung 15 (von dem Zahnrad 17 weg) begrenzt in vertikaler Richtung 15 beweglich gelagert sein. Dadurch kann eine sichere Kopplung mit der elastischen Antriebsvorrichtung 6 ermöglicht werden, wobei zudem ein Montageaufwand durch eine verminderte Verkantungsneigung sowie eine Geräuschentwicklung durch elastische respektive flexible Deformation reduziert werden. Zum Beispiel kann die Zahnstange 9 in Richtung des Zahnrades 17 durch eine Feder oder über Eigenelastizität vorbelastet sein, um einen Formschluss zur elektrischen Antriebsvorrichtung 6 im Betrieb sicherstellen zu können.

Besonders bevorzugt ist die Zahnstange 9 flexibel ausgebildet, um durch elastische Verformung eine sichere, harmonische und kontinuierliche Bewegungsübertragung gewährleisten zu können.

Durch die lösbare Verbindung - insbesondere die doppelte lösbare Verbindung - kann über die beteiligten Bauteilkomponenten eine Überlastkupplung konstituiert werden, wodurch auf eine Überlastkupplung 68 der elektrischen Antriebseinheit 6 verzichtet werden kann. Beispielsweise kann durch eine im Belastungsfall dadurch bedingte Toleranz in der Interaktion zwischen dem Zahnrad 17 und der Zahnstange 9 unter erhöhter Belastung der Zahnstange 2 (beispielsweise bei Erschütterungen oder unsachgemäßen Krafteinwirkungen auf das bewegbare Möbelteil 2) verhindert werden, dass eine vollständige Entkoppelung zwischen der elektrischen Antriebsvorrichtung 6 und der Zahnstange 9 erfolgt - ohne die Wirkung einer Überlastkupplung zu verlieren, wodurch die Position der Ladenschiene 5 relativ zu der Korpusschiene 4 eindeutig über die relative Stellung zwischen der Zahnstange 9 und dem Zahnrad 17 bestimmbar bleibt. Eine Entkopplung zum Elektromotor 7 ist nicht erforderlich und kann beispielsweise über eine Freilaufkupplung 29 generiert werden. Eine erforderliche Referenzfahrt kann unterbunden werden, wobei die Trägereinrichtung 10 als Koppeleinrichtung agiert.

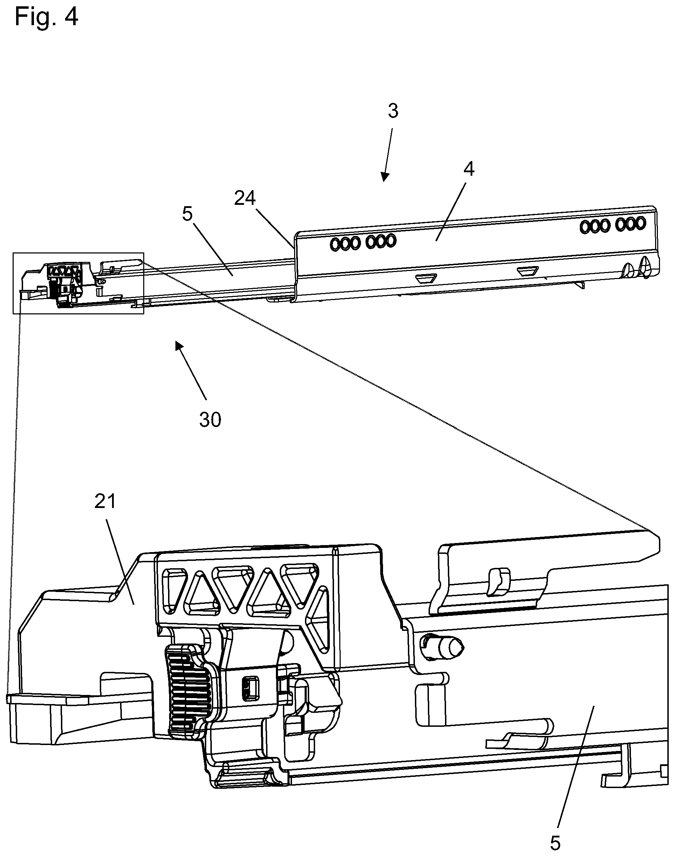

Fig. 4 zeigt die Führungsvorrichtung 3 mit einem vergrößerten Detailausschnitt der Ladenschiene 5 im Bereich einer möbelteilrückseitigen Kopplungseinrichtung für das bewegbare Möbelteil 2.

Die Ladenschiene 5 umfasst eine Lagervorrichtung 21 für die Zahnstange 9, wobei die Lagervorrichtung 21 an der Ladenschiene 5 und der Zahnstange 9 angeordnet ist, wobei ein Träger 22 der elektrischen Antriebsvorrichtung 6 zur Anbindung der elektrischen Antriebsvorrichtung 6 an der Korpusschiene 4 im Zuge einer relativen Bewegung zwischen der Ladenschiene 5 und der Korpusschiene 4 von der Zahnstange 9 und der Lagervorrichtung 21 überfahrbar ist.

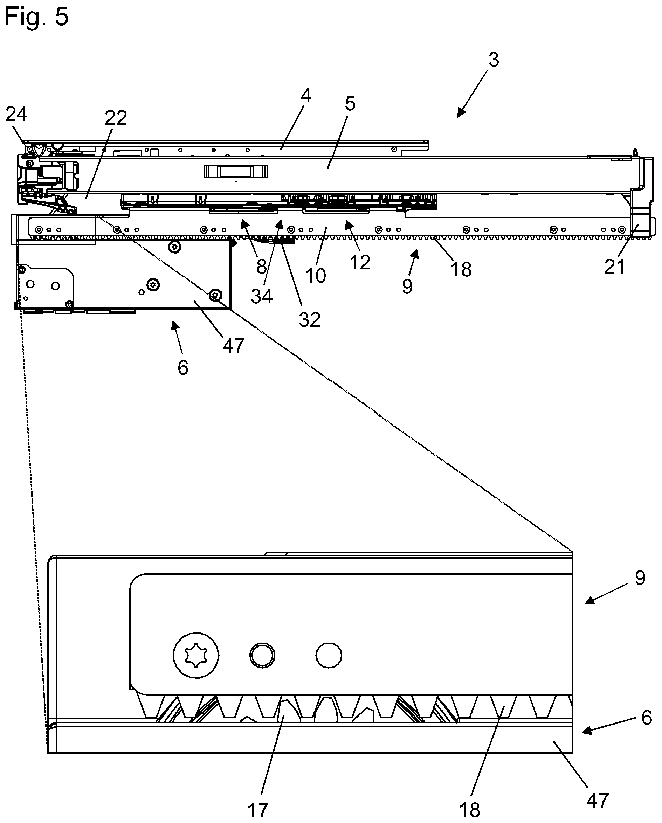

Fig. 5 zeigt die Führungsvorrichtung 3, wobei im vergrößerten Detailausschnitt die Kopplung zwischen einem in Wirkverbindung mit dem Elektromotor 7 stehenden Zahnrad 17 der elektrischen Antriebsvorrichtung 6 und einer Verzahnung 18 der Zahnstange 9 dargestellt ist.

Der Elektromotor 7 (beziehungsweise die elektrische Antriebsvorrichtung 6) umfasst in der Kopplung mit Getriebestufen 55 der elektrischen Antriebsvorrichtung 6 ein mit der Zahnstange 9 kämmendes Zahnrad 17.

Das Zahnrad 17 ist in Gebrauchsstellung 14 der Anordnung in horizontaler Richtung 16 in Richtung der Ladenschiene 5 weisend ausgerichtet, wobei auch ein in vertikaler Richtung 15 nach oben orientiertes Zahnrad 17 der elektrischen Antriebsvorrichtung 6 möglich ist.

Die Zahnstange 9 ist zwischen der elektrischen Antriebsvorrichtung 6 und der Ladenschiene 5 angeordnet. Die Führungsvorrichtung 3 liegt in Schließstellung vor, wobei ein an der Ladenschiene 5 angeordnetes bewegbares Möbelteil 2 in einer Endlage verortet sein würde.

Um ein Maß einer Kraftübertragung durch die über die elektrische Antriebsvorrichtung 6 vermittelte Energie auf das bewegbare Möbelteil hinsichtlich eines Zeitpunktes und/oder einer Intensität zu verbessern, wird die elektrische Antriebsvorrichtung durch einen Mikrokontroller 37 angesteuert, welcher als Steuerungs- und/oder Regelungseinrichtung 44 fungiert und als Recheneinheit agiert.

Ein exemplarisches recheneinheitgestütztes Verfahren zur Bewegung des bewegbaren Möbelteiles 2 relativ zu dem feststehenden Möbelteil 1 entlang der Führungsvorrichtung 3 durch die elektrische Antriebsvorrichtung 6 zur zumindest bereichsweise automatisierten Bewegung des bewegbaren Möbelteiles 2 gegenüber dem feststehenden Möbelteil 1 über einen Elektromotor 17 kann wie folgend umgesetzt werden: Der Mikrokontroller 37, umfassend die Recheneinheit und eine in mit der Recheneinheit in Datenverbindung stehende Speichereinheit, ermittelt in Abhängigkeit zumindest eines in der Speichereinheit hinterlegten statischen Datensatzes ein Modell des bewegbaren Möbelteiles 2, das bewegbare Möbelteil 2 wird ausgehend von einer partiellen oder vollständigen Öffnungsstellung 30 und einer Schließstellung manuell in Richtung der Schließstellung bewegt oder vice versa und der Mikrokontroller 37 berechnet in Abhängigkeit zumindest eines dynamischen Datensatzes eine prognostizierte Bewegungstrajektorie des bewegbaren Möbelteiles 2 entlang der Führungsvorrichtung 3.

Der statische Datensatz kann beispielsweise eine Masse des bewegbaren Möbelteiles 2, eine Reibung des bewegbaren Möbelteiles 2 an der Führungsvorrichtung 3, eine Dimensionierung des bewegbaren Möbelteiles 2, eine Beladung in dem bewegbaren Möbelteil 2, eine Dimensionierung der Führungsvorrichtung 3, eine Wegstrecke 13 entlang der Führungsvorrichtung 3, Toleranzgrenzen et cetera umfassen.

Die Wegstrecke 13 kann im Allgemeinen durch einen Auszugsweg für das bewegbare Möbelteil 2 oder eine Längserstreckung der Zahnstange 9 bedingt sein, über welche zumindest partiell ein Antrieb durch die elektrische Antriebsvorrichtung 6 über eine automatisierte Ansteuerung erfolgt. Ein Antrieb über die Wegstrecke 13 ist möglich; ein Antrieb über Teilbereiche der Wegstrecke 13 ist bevorzugt.

Der dynamische Datensatz kann beispielsweise einen von dem bewegbaren Möbelteil 2 relativ zu dem feststehenden Möbelteil 1 zurückgelegten Absolutweg, eine Geschwindigkeit des bewegbaren Möbelteiles 2, eine Beladung in dem bewegbaren Möbelteil 2, ein (im Allgemeinen über eine Geschwindigkeitsmesseinrichtung 52 ermitteltes) Beschleunigungsprofil des bewegbaren Möbelteiles 2, einen Beschleunigungsweg des bewegbaren Möbelteiles 2, eine kinetische Energie des bewegbaren Möbelteiles 2 et cetera umfassen.

Der statische Datensatz oder der dynamische Datensatz kann in einer Referenzfahrt des bewegbaren Möbelteiles 2 oder über eine Vielzahl an Referenzfahrten - gegebenenfalls mit variierenden Beladungen des bewegbaren Möbelteiles 2 - bestimmt werden. Es ist alternativ oder in Ergänzung möglich, statische Datensätze in einer Speichereinheit ohne Referenzfahrt zu hinterlegen und statische Datensätze oder dynamische Datensätze mit in der Speichereinheit hinterlegten Datensätze zu vergleichen oder in Abhängigkeit hinterlegter Datensätze zu korrigieren.

Die folgenden Aspekte sind bei dieser Ausführungsform vorgesehen, müssen jedoch nicht zwingend umgesetzt werden:
Der Mikrokontroller 37 trifft in Abhängigkeit der prognostizierten Bewegungstrajektorie eine Entscheidung, ob die elektrische Antriebsvorrichtung 6 das bewegbare Möbelteil 2 mit Kraft beaufschlagen soll, oder ob das bewegbare Möbelteil 2 manuell in einem Freilaufbereich bewegbar sein soll. Der Elektromotor 7 umfasst eine Freilaufkupplung 29, mit welcher eine Kraftübertragung von dem Elektromotor 7 auf das bewegbare Möbelteil 2 im Freilaufbereich getrennt wird.

Der Mikrokontroller 37 berechnet in Abhängigkeit des zumindest einen statischen Datensatzes und des zumindest einen dynamischen Datensatzes, ob das bewegbare Möbelteil 2 die Schließstellung ohne Kraftbeaufschlagung über die elektrische Antriebsvorrichtung 6 erreicht, wobei eine Geschwindigkeit des bewegbaren Möbelteiles 2 mit Eintritt in die Schließstellung in Abhängigkeit einer Dämpfleistung einer an dem bewegbaren Möbelteil 2 oder dem feststehenden Möbelteil 1 angeordneten Dämpfvorrichtung 12 ermittelt wird.

Der Mikrokontroller 37 definiert in Abhängigkeit der prognostizierten Bewegungstrajektorie ein Geschwindigkeitsprofil für den über die elektrische Antriebsvorrichtung 6 vermittelten Antrieb des bewegbaren Möbelteiles 2, wobei die elektrische Antriebsvorrichtung 6 das bewegbare Möbelteil 2 in Abhängigkeit des Geschwindigkeitsprofils mit Kraft beaufschlagt. Das Geschwindigkeitsprofil wird in Abhängigkeit des zumindest einen statischen Datensatzes oder des zumindest einen dynamischen Datensatzes erstellt, wobei das bewegbare Möbelteil 2 bei einer Geschwindigkeit des bewegbaren Möbelteiles 2 unterhalb des Geschwindigkeitsprofils mit Energie beaufschlagt wird und bei einer Geschwindigkeit des bewegbaren Möbelteiles 2 oberhalb des Geschwindigkeitsprofils durch die elektrische Antriebsvorrichtung 6 gebremst wird sowie bei einem vordefinierten Geschwindigkeitsschwellwert oder einem vordefinierten Positionsschwellwert eine Kraftübertragung auf das bewegbare Möbelteil 2 initiiert wird.

Dem Mikrokontroller 37 ist ein Lernalgorithmus in Form einer künstlichen Intelligenz umfassend ein neuronales Netzwerk mit maschinellem Lernen oder Deep Learning hinterlegt, wobei mit dem Lernalgorithmus die prognostizierten Bewegungstrajektorien einer Historie analysiert und miteinander verglichen werden. Die Historie an prognostizierten Bewegungstrajektorien wird in Abhängigkeit der jeweiligen statischen Datensätze oder dynamischen Datensätze für zukünftig zu prognostizierende Bewegungstrajektorien, zukünftige Geschwindigkeitsprofile oder zukünftige Entscheidungen zur Kraftbeaufschlagung des bewegbaren Möbelteiles 2 herangezogen.

Als Trainingsdaten für die künstliche Intelligenz werden Bewegungsabläufe des bewegbaren Möbelteiles 2 entlang einer Führungsvorrichtung 3 genutzt. Besonders vorteilhaft hat sich erwiesen, wenn unterschiedliche Führungsvorrichtungen 3 und variierende Kraftbeaufschlagungen oder Beladungen des bewegbaren Möbelteiles 2 zum Training des Lernalgorithmus verwendet werden. Bewegungsabläufe an der konkret vorliegenden Führungsvorrichtung sowie dem spezifischen bewegbaren Möbelteil 2 können zu Lernzwecken den Trainingsdaten - insbesondere kontinuierlich -hinzugefügt werden.

Die elektrische Antriebsvorrichtung 6 verbleibt bei einer Bewegung des bewegbaren Möbelteiles 2 stationär an der Korpusschiene 4 und steht in stetiger Verbindung mit der an der Ladenschiene 5 angeordneten Zahnstange 9.

Das bewegbare Möbelteil 2 ist über die Ladenschiene 5 ausgehend von der Öffnungsstellung 30 oder einer Stellung zwischen der Öffnungsstellung 30 und der Schließstellung über eine gesamte Wegstrecke 13 bis zu der Schließstellung und zu der Öffnungsstellung 30 oder nur über einen Teilbereich der Wegstrecke 13 durch die elektrische Antriebsvorrichtung 6 antreibbar, wobei eine Kraftbeaufschlagung durch die elektrische Antriebsvorrichtung 6 ausgehend von der Schließstellung in Richtung der Öffnungsstellung 30 durch Überdrückbewegung des bewegbaren Möbelteiles 2 oder über einen ausschließlich elektronischen Auslösesensor 59 initiiert wird. Das bewegbare Möbelteil 2 ist in einem nicht angetriebenen Teilbereich der Wegstrecke 13 in einem Freilaufbereich manuell bewegbar, sodass keine Kraftbeaufschlagung vom Elektromotor 7 auf das bewegbare Möbelteil 2 erfolgt.

Angetriebene Teilbereiche der Wegstrecke 13 haben sich in Richtung der Öffnungsstellung 30 - insbesondere ausgehend von der Schließstellung - zwischen 50 mm und 150 mm und in Richtung der Schließstellung - insbesondere ausgehend von der vollständigen Öffnungsstellung 30 - zwischen 5 mm und 20 mm als besonders günstig erwiesen.

Eine Bewegung des bewegbaren Möbelteiles 2 in Richtung der Schließstellung oder der Öffnungsstellung 30 kann über die elektrische Antriebsvorrichtung 6 gedämpft, gebremst oder gesperrt werden, wobei das bewegbare Möbelteil 2 im Bereich der Schließstellung durch eine Zuzieheinrichtung 8 mit Kraft in Richtung der Schließstellung beaufschlagt wird. Eine Zuzieheinrichtung 8 ist jedoch nicht zwingend erforderlich, wobei die Zuzieheinrichtung 8 beispielsweise durch die elektrische Antriebsvorrichtung 6 ersetzt werden kann.

Ein Algorithmus oder ein Computerprogrammprodukt, umfassend Befehle für die Ausführung des Verfahrens kann dem Mikrokontroller 37 oder der Steuerungs- und/oder Regelungseinrichtung 44 hinterlegt sein, auf einem Datenträgersignal übertragen werden oder auf einem - insbesondere nicht flüchtigen - Datenträger gespeichert sein.

Die Recheneinheit des Mikrokontrollers 37 oder der Steuerungs- und/oder Regelungseinrichtung 44 ist dazu konfiguriert, in Abhängigkeit des zumindest einen in der Speichereinheit hinterlegten statischen Datensatzes ein Modell des bewegbaren Möbelteiles 2 zu ermitteln und in Abhängigkeit des zumindest einen - gegebenenfalls in der Speichereinheit hinterlegten - dynamischen Datensatzes eine prognostizierte Bewegungstrajektorie des bewegbaren Möbelteiles 2 entlang der Führungsvorrichtung 3 zu berechnen. Die elektrische Antriebsvorrichtung 6 umfasst die Recheneinheit.

Die Speichereinheit weist eine hinreichende Speicherkapazität auf, um die für das Modell erforderlichen Informationen bereitzustellen. Die Recheneinheit weist eine hinreichende Rechenleistung auf, um das Modell in für die Anwendung in der Möbelbranche benötigten Genauigkeit in Bezug auf ein auf das bewegbare Möbelteil 2 zu transferierende Geschwindigkeitsprofil zu berechnen. Die Speicherkapazität und die Rechenleistung kann in Abhängigkeit einer gewünschten Präzision des Modelles oder einer gewünschten Genauigkeit eines aus dem Modell zu generierenden Outputparameters, wie das Geschwindigkeitsprofil, angepasst sein.

Das Geschwindigkeitsprofil umfasst bevorzugt eine Amplitude der Beschleunigung, einen Weg der Beschleunigung, die Wegstrecke 13 oder einen Teilbereich der Wegstrecke 13 über welchen das bewegbare Möbelteil 2 mit Geschwindigkeit behaftet sein soll oder angetrieben sein soll, eine Maximalgeschwindigkeit und dergleichen. Als Inputparameter kann beispielsweise eine derzeitig vorliegende Beladung des bewegbaren Möbelteiles 2 oder eine Impulsübertragung (diskret oder kontinuierlich) von dem Bediener des bewegbaren Möbelteiles 2 als dynamischer Parameter genutzt werden.

Durch das Verfahren und insbesondere den Mikrokontroller 37 oder die Steuerungs- und/oder Regelungseinrichtung 44 kann eine Unterstützungserkennung für eine Bewegung des bewegbaren Möbelteiles 2 generiert werden, wobei das bewegbare Möbelteil 2 in Schließrichtung oder in Öffnungsrichtung beispielsweise derart angetrieben werden kann, dass das bewegbare Möbelteil 2 im Wesentlichen geräuschlos und/oder ohne maßgebliche Krafteinwirkung auf die Bauteilkomponenten in eine Endlage (Schließstellung oder Öffnungsstellung 30) bewegt wird. Im Allgemeinen ist ein partieller Antrieb oder ein vollständiger Antrieb - insbesondere über die gesamte Wegstrecke 13 - in die Endlage möglich.

Durch die gegenüber dem Stand der Technik erhöhte Funktionalität des Verfahren können - insbesondere bei wechselnden Kraftbeaufschlagungen und/oder Beladungen des bewegbaren Möbelteiles 2 oder variierenden Führungsvorrichtungen 3 - unterwünscht disharmonische Bewegungstrajektorien unterbunden werden, wobei unsachgemäß hohe oder niedrige Geschwindigkeiten des bewegbaren Möbelteiles 2 unterbunden werden können, welche keine Bewegung in eine gewünschte Endlage des bewegbaren Möbelteiles 2 ermöglichen oder Beschädigungen bedingen können.

Der Mikrokontroller 37 kann als Steuerungs- und/oder Regelungseinrichtung 44 aufgefasst werden oder eine solche als Recheneinheit umfassen.

Fig. 6 zeigt, dass die elektrische Antriebsvorrichtung 6 eine Vielzahl an gegenüber dem feststehenden Möbelteil 1 stationäre Beleuchtungsmittel 31 umfasst, wobei im Allgemeinen auch lediglich ein Beleuchtungsmittel 31 vorgesehen sein kann. Das Beleuchtungsmittel 31 ist an der elektrischen Antriebsvorrichtung 6 angeordnet.

Ein Beleuchtungsmittel 31 liegt in Form einer Lampe 38 - als LED-Lampe ausgebildet - vor und ist in der elektrischen Antriebsvorrichtung 6 bereichsweise in dem Gehäuse 47 der elektrischen Antriebsvorrichtung 6 integriert.

Ein weiteres Beleuchtungsmittel 31 liegt in Form eines leistenartigen Leuchtmittel 40 - als LED-Leiste ausgestaltet - vor und ist unmittelbar an der elektrischen Antriebsvorrichtung 6 angeordnet. In punktierter Linie ist angedeutet, dass das weitere Beleuchtungsmittel 31 auch beispielsweise in Form eines flächigen Leuchtmittel 39 - hierbei als LED-Fläche vorgesehen - vorliegen kann. Zum Beispiel kann das weitere Beleuchtungsmittel 31 auch mittelbar an der elektrischen Antriebsvorrichtung 6 angeordnet sein - beispielsweise durch eine Anbindung einer (aus Übersichtlichkeitsgründen nicht dargestellten) Stromleitung 32 an die Stromleitung 32 der elektrischen Antriebsvorrichtung 6.

Die Beleuchtungsmittel 31 sind derart an einer Unterseite der elektrischen Antriebsvorrichtung 6 orientiert, dass durch die Beleuchtungsmittel 31 die weiteren bewegbaren Möbelteile 42 beleuchtbar sind, wobei die Beleuchtungsmittel 31 an der elektrischen Antriebsvorrichtung 6 des ersten bewegbaren Möbelteiles 41 angeordnet sind. Die Beleuchtungsmittel 31 können jedoch im Allgemeinen alternativ oder in Ergänzung derart an der elektrischen Antriebsvorrichtung 6 oder der Stromleitung 32 der elektrischen Antriebsvorrichtung 6 des ersten bewegbaren Möeblteiles 41 angeordnet sein, dass durch die Beleuchtungsmittel 31 das erste bewegbare Möbelteil 41 beleuchtbar ist.

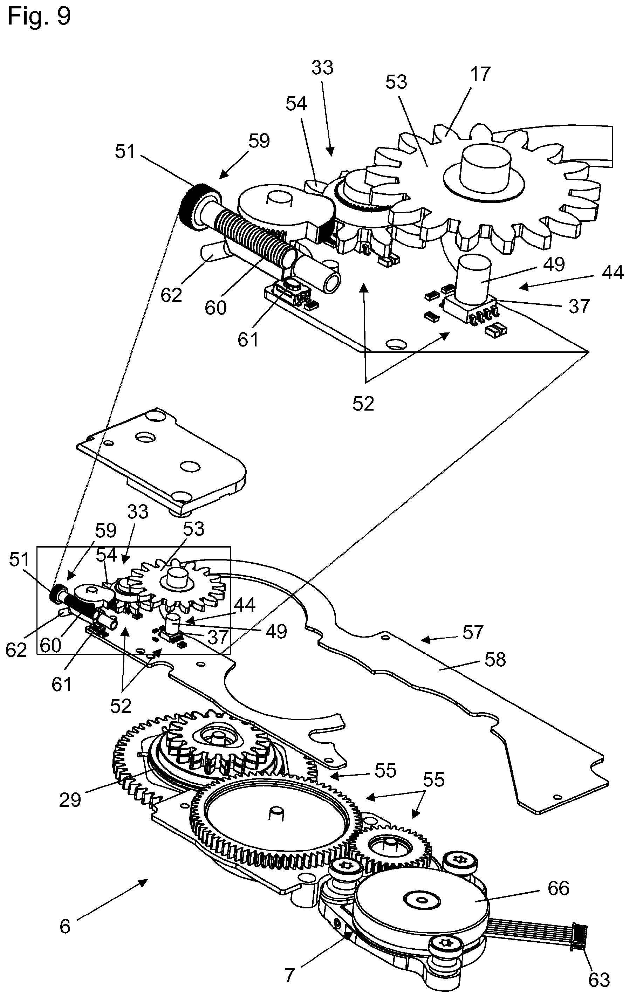

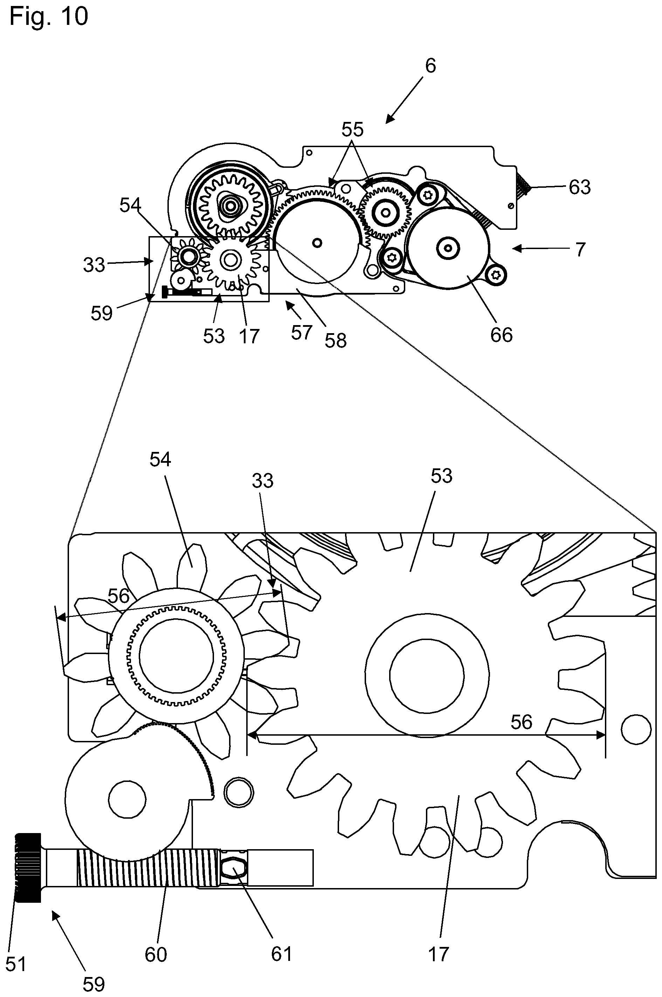

Wie in Fig. 9 und Fig. 10 noch näher erläutert wird, ist eine Wegmesseinrichtung 33 vorgesehen, welche alternativ oder in Ergänzung zu dem schematisch angedeuteten Bewegungssensor 43 herangezogen werden kann, um eine relative Stellung - wie eine vollständige oder partielle Öffnungsstellung 30 des bewegbaren Möbelteiles 2 relativ zu dem feststehenden Möbelteil 1 zu detektieren. Die Beleuchtungsmittel 31 sind in Abhängigkeit der ermittelten relativen Stellung durch eine Steuerungs- und/oder Regelungseinrichtung 44 oder einen Mikrokontroller 37 aktivierbar. Die Wegmesseinrichtung 33 und der Bewegungssensor 43 sind an der elektrischen Antriebsvorrichtung 6 angeordnet und mit der Stromleitung 32 der elektrischen Antriebsvorrichtung 6 sowie den Beleuchtungsmitteln 31 gekoppelt. Im Allgemeinen kann alternativ oder in Ergänzung zur Wegmesseinrichtung 33 oder dem Bewegungssensor 43 die Distanzsensorik 50 (siehe Fig. 1b) für die Bestimmung der relativen Stellung zur Auslösung der Beleuchtungsmittel 31 genutzt werden. Die Anzahl an Beleuchtungsmittel 31 ist im Allgemeinen beliebig.

Die Beleuchtungsmittel 31 sind zwischen den beiden Korpusschienen 4 der Führungsvorrichtung 3 angeordnet, wobei das leistenartige Leuchtmittel 40 seitlich zwischen den Korpusschienen 4 verortet ist und sich vollständig linienförmig zwischen den zwei Korpusschienen 4 hinweg erstreckt.

Zwischen den beiden Korpusschienen 4 besteht eine direkte Stromverbindung, welche zur Beleuchtung des bewegbaren Möbelteiles 2 genutzt werden kann, wobei die Stromverbindung beziehungsweise die Stromversorgung über zumindest eine der zwei Korpusschienen 4 oder die Zahnstange 9 geführt ist. Die elektrische Antriebsvorrichtung 6 ist an einer der beiden Korpusschienen 4 stationär angeordnet und die Zahnstange 9 ist zur stetigen Bewegungsübertragung von einem Zahnrad 17 der elektrischen Antriebsvorrichtung 6 auf die Ladenschiene 5 an der Ladenschiene 5 der Führungsvorrichtung 3 angeordnet. Die elektrische Antriebsvorrichtung 6 und die Stromleitung 32 für die elektrische Antriebsvorrichtung 6 und für die Beleuchtungsmittel 31 sind stationär an der Führungsvorrichtung 3 - an der Korpusschiene 4 - angeordnet.

Über eine Steuerungs- und/oder Regelungseinrichtung 44 oder einen Mikrokontroller 37 kann das bewegbare Möbelteil 2 über die elektrische Antriebsvorrichtung 6 mit Kraft beaufschlagt werden, sodass die Anbindung an die Korpusschiene 4 eine Doppelfunktion bedingt. Die Elektrische Antriebsvorrichtung 6 ist dazu ausgebildet, das bewegbare Möbelteil 2 zumindest bereichsweise relativ zu dem feststehenden Möbelteil 1 zu bewegen, wobei die elektrische Antriebsvorrichtung 6 die an der elektrischen Antriebsvorrichtung 6 oder der Stromleitung 32 der elektrischen Antriebsvorrichtung 6 angeordneten Beleuchtungsmittel 31 umfasst.

Ein exemplarisches Verfahren zum Beleuchten eines bewegbaren Möbelteiles 2 (gegebenenfalls das weitere bewegbare Möbelteil 42) kann wie folgend expliziert werden: Das bewegbare Möbelteil 2 wird relativ zu dem feststehenden Möbelteil 1 entlang der Führungsvorrichtung 3 durch die eine elektrische Antriebsvorrichtung 6 zumindest bereichsweise automatisiert bewegt und das an der elektrischen Antriebsvorrichtung 6 oder an der Stromleitung 32 der elektrischen Antriebsvorrichtung 6 angeordnete Beleuchtungsmittel 31 wird aktiviert, sodass das bewegbare Möbelteil 2 durch das Beleuchtungsmittel 31 beleuchtet wird, wobei das bewegbare Möbelteil 2 bewegt wird und das Beleuchtungsmittel 31 stationär verbleibt. Im Speziellen wird das weitere bewegbare Möbelteil 42 durch das Beleuchtungsmittel 31 in Abhängigkeit einer Bewegung des ersten bewegbaren Möbelteiles 41 beleuchtet, wobei das Beleuchtungsmittel 31 stationär an der elektrischen Antriebsvorrichtung 6 des ersten bewegbaren Möbelteil 41 verbleibt. Hierzu wird die relative Stellung des weiteren bewegbaren Möbelteiles 42 detektierbar, wobei das Beleuchtungsmittel 31 in Abhängigkeit der ermittelten relativen Stellung über eine Steuerungs- und/oder Regelungseinrichtung 44 oder den Mikrokontroller 37 aktiviert wird. Beispielsweise kann ein Algorithmus oder ein Computerprogrammprodukt in der Steuerungs- und/oder Regelungseinrichtung 44 oder dem Mikrokontroller 37 hinterlegt sein, welcher/welches Befehle umfasst, die bei einer Ausführung durch eine Recheneinheit diese veranlassen, aus einer Speichereinheit, welche mit der Recheneinheit in einer Datenverbindung steht, das Verfahren auszuführen.

Bevorzugt wird Licht im sichtbaren Wellenlängenbereich emittiert, wobei beispielsweise vorgesehen kann, dass ein Wellenlängenbereich und/oder eine Intensität des Beleuchtungsmittels 31 - gegebenenfalls über die elektrische Antriebsvorrichtung 6 oder eine Empfangseinheit der elektrischen Antriebsvorrichtung 6 zur Konfiguration der elektrischen Antriebsvorrichtung 6 - änderbar und/oder einstellbar ist.

Im Allgemeinen kann mit einem Beleuchtungsmitteln 31 alternativ oder in Ergänzung auch beispielsweise Licht im Infrarotbereich zur Erwärmung oder Licht im UV-Wellenlängenbereich - insbesondere UVC-Wellenlängenbereich - zur Entkeimung oder Desinfektion emittiert werden. Dadurch kann Staugut oder eine Oberfläche von unerwünschten Mikroorganismen befreit werden oder ein Innenraum des bewegbaren Möbelteiles 2 auf eine gewünschte Temperatur geregelt werden, um zum Beispiel Lebensmittel - insbesondere in Kombination mit einer Vakuumschublade und gegebenenfalls einstellbar - mit variierender Intensität oder einstellbaren Wellenlängenbereich bestrahlen zu können. Die Positionierung an einer stationären elektrischen Antriebsvorrichtung 6 oberhalb des Staugutraumes eignet sich hierfür besonders. Eine Verriegelungsvorrichtung in Abhängigkeit einer Aktivierung des Beleuchtungsmittels 31 ist ebenfalls denkbar.

Grundsätzlich ist eine Energieversorgung durch Einbringung von Strom in das bewegbare Möbelteil 2 aufwändig und umständlich, da die Bewegung des bewegbaren Möbelteiles 2 berücksichtigt werden muss. Eine Beleuchtung des bewegbaren Möbelteiles 2 hat jedoch den Vorteil, im bewegbaren Möbelteil 2 befindliches Staugut - insbesondere bei mangelhaften Lichtverhältnissen oder bei Nacht - eindeutig identifizieren zu können. Insbesondere bei einer ortsfest an der Korpusschiene 4 angeordneten elektrischen Antriebsvorrichtung 6 kann die Einbringung des Stroms über die Korpusschiene 4 in einer Doppelfunktion auch dazu genutzt werden, Energie für die Versorgung des Beleuchtungsmittels 31 in besonders vorteilhafter Weise zu nutzen.

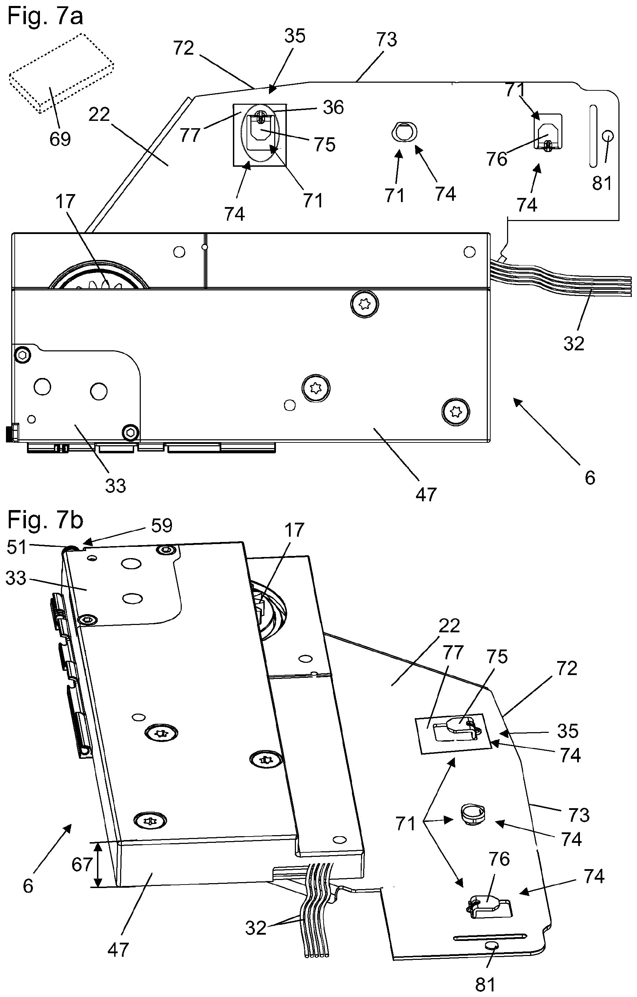

Fig. 7a zeigt eine elektrische Antriebsvorrichtung 6 mit dem mit 230 V versorgbaren Elektromotor 7, wobei die elektrische Antriebsvorrichtung 6 einen plattenförmigen Träger 22 zur Anordnung an der Korpusschiene 4 der Führungsvorrichtung 3 umfasst, wobei der Träger 22 eine Schrägfläche 72 umfasst, welche dergestalt ist, dass die elektrische Antriebsvorrichtung 6 an einer an dem feststehenden Möbelteil 1 angeordneten Korpusschiene 4 im montierten Zustand (vgl. Fig. 6 in Verbindung mit Fig. 1b) kollisionsfrei über einen Einschwenkvorgang montierbar ist.

Die elektrische Antriebsvorrichtung 6 weist eine Längsrichtung 27 auf und die Schrägfläche 72 des Trägers 22 ist in einem spitzen Winkel zwischen 5° und 30° relativ zu der Längsrichtung 27 orientiert.

Die Schrägfläche 72 zur Anordnung an der Korpusschiene 4 ist an einem quer von der elektrischen Antriebseinheit 6 abstehenden freien Ende 73 des Trägers 22 und räumlich beabstandet von der elektrischen Antriebsvorrichtung 6 sowie dem Elektromotor 7 angeordnet.

Die elektrische Antriebsvorrichtung 6 umfasst an dem Träger 22 zwei Koppelvorrichtungen 74 zur Anbindung an eine zweite Schnittstelle 35 der Korpusschiene 4, wobei im Allgemeinen eine Koppelvorrichtung 74 ausreichend ist. Eine Koppelvorrichtung 74 liegt in Form eines aus einem Blech gestanzten und gebogen Hakens 75 vor, wobei an dem Träger 22 ein weiterer Haken 76 als Gegenlager für die Anbindung der elektrischen Antriebsvorrichtung 6 an der Korpusschiene 4 vorgesehen ist. Beispielsweise kann an dem weiteren Haken 76 ein Mitnehmer 36 für die Zuzieheinrichtung 8 oder eine Ausstoßeinrichtung 11 (gegebenenfalls mit Tip-On-Funktion) angeordnet sein. Der weitere Haken 76 kann als zweite Schnittstelle 35 genutzt werden.

Eine weitere Koppelvorrichtung 74 liegt (analog zu den beiden Koppelvorrichtung 74 als Haken/weiterer Haken 75, 76) als Clipverbindung 71 vor. Die weitere Koppelvorrichtung 74 ist als Rastbuckel 81 ausgebildet. Die elektrische Antriebsvorrichtung 6 kann über den Rastbuckel 81 und den Träger 22 translatorisch an die Korpusschiene 4 aufgesteckt werden und über die beiden Haken in einem Einschwenkvorgang lagesicher an der Korpusschiene 4 fixiert werden, wobei im Allgemeinen bereits über den Rastbuckel 81 eine lagesichere Fixierung erfolgen kann.

Der Rastbuckel 81 kann im Zuge einer Montage - bedingt durch eine seitlich daneben vorgesehene Aussparung im Material - elastisch in eine korrespondierende Vertiefung zur Fixierung eintauchen. Zwischen den Haken 75, 76 ist ein Fortsatz ersichtlich, welcher als Drehachse für eine Rotationsbewegung nach translatorischer Kontaktierung agiert. Im Allgemeinen kann eine Fixierung auch beispielsweise durch einen einrastbaren Steg über eine rein translatorische Bewegung im Sinne einer Clipverbindung vorgesehen sein.

Die Koppelvorrichtung 72 in Form des Hakens 75 überlappt mit einer Öffnung 77 des Trägers 22. Die Öffnung 77 weist hierbei eine Doppelfunktion in Verbindung mit einem Fertigungsprozess des Trägers 22 auf, da die Öffnung 77 beispielsweise als Haltevorrichtung (zum Beispiel für ein Handling oder eine Beschichtung) in der Produktion genutzt werden kann. Die Öffnung 77 kann im Allgemeinen alternativ oder in Ergänzung auch an der Korpusschiene 4 angeordnet sein, wobei auch hier die Doppelfunktion in Bezug auf die Verbindung sowie dem Herstellungsverfahren genutzt werden kann. Der Haken 75 ragt durch die Öffnung 77 des Trägers 22(oder der Korpusschiene 4). Die elektrische Antriebsvorrichtung 6 kann im Allgemeinen mittelbar über den Träger 22 an der Korpusschiene 4 angeordnet werden. Der Träger 22 kann mehrteilig ausgebildet sein. Der Haken 75 oder der Rastbuckel 81 kann im Allgemeinen als kinematische Umkehr an der Korpusschiene 4 angeordnet sein. Die Öffnung 77 oder eine Mehrteiligkeit des Trägers 22 ist im Allgemeinen nicht erforderlich. Bevorzugt liegt eine Öffnung 77 in der Korpusschiene 4 vor, in welche der Haken 75 eingreift, wobei diese Öffnung 77 die Position der Korpusschiene 4 in einer Anlage zur Fertigung der Korpusschiene 4 definiert. An dem Haken 74 kann eine weitere Bewegungstechnologie angebunden werden.

Ein exemplarisches Verfahren zum Nachrüsten der elektrischen Antriebsvorrichtung 6 an der Führungsvorrichtung 3 im eigebauten Zustand der Führungsvorrichtung 3 kann wie folgend expliziert werden: Die elektrische Antriebsvorrichtung 6 zur zumindest bereichsweise automatisierten Bewegung des bewegbaren Möbelteiles 2 wird bereitgestellt und die Führungsvorrichtung 3 wird an dem feststehenden Möbelteil 1 (siehe Fig. 1a) zur Führung des bewegbaren Möbelteiles 2 relativ zu dem feststehenden Möbelteil 1 montiert, wobei gegebenenfalls eine Ausstoßeinrichtung 11, eine Zuzieheinrichtung 8, ein Mitnehmer 36 für die Ausstoßeinrichtung 11 oder ein Mitnehmer 36 für die Zuzieheinrichtung 8 von der Führungsvorrichtung 3 entfernt wird. Anschließend wird die elektrische Antriebsvorrichtung 6 im Wesentlichen vollständig (gegebenenfalls mit nach unten überstehender Möbelteilfront 23) unterhalb des zu bewegenden bewegbaren Möbelteiles 2 an der zweiten Schnittstelle 35 der Korpusschiene 4 angeordnet und die Zahnstange 9 wird zur Kraftübertragung von der elektrischen Antriebsvorrichtung 6 auf die Ladenschiene 5 an der ersten Schnittstelle 34 der Ladenschiene 5 angeordnet.

Die erste Schnittstelle 34 der Ladenschiene 5 kann im Allgemeinen durch eine Zuzieheinrichtung 8 gegeben sein.

An der zweiten Schnittstelle 35 kann eine Verriegelungsvorrichtung 69 (schematisch in punktierten Linien angedeutet) zur Sperrung einer Bewegung des bewegbaren Möbelteiles 2 gegenüber dem festsehenden Möbelteil 1 und ein Mitnehmer 36 für eine Ausstoßeinrichtung 11 angeordnet sein. Der Mitnehmer 36 für die in dieser Ausführungsform vorgesehene Zuzieheinrichtung 8 ist in punktierter Linie an der zweiten Schnittstelle angedeutet.

Die Schrägfläche 72 reduziert die Gefahr einer Kollision mit dem feststehenden Möbelteil 1 oder der Korpusschiene 4 im Zuge der Montage der elektrischen Antriebsvorrichtung 6 an der Korpusschiene 4, wobei die elektrische Antriebsvorrichtung 6 als Add-On an bestehende Führungsvorrichtungen 3 angebunden werden kann. Die Zahnstange 9 (oder Äquivalente) kann ebenfalls nachträglich an die Ladenschiene 9 zur Bewegungsvermittlung von der elektrischen Antriebsvorrichtung 6 auf das bewegbare Möbelteil 2 gekoppelt werden. Die Schnittstellen 34, 35 in Verbindung mit den daran anzuordnenden Bauteilkomponenten umfassen daher eine Multifunktion - einerseits für die Gewährleistung einer benutzerfreundlichen Nachrüstbarkeit und andererseits zur Anbindung einer Vielzahl an flexibel austauschbaren sowie variierenden Bewegungstechnologien. Mehrere Schnittstellen für eine Vielzahl an Bewegungstechnologien kann dadurch vermieden werden, wobei einzelne Bewegungstechnologien als Add-On montagefreundlich angebunden werden können. Zusätzlicher Bauraum für die Anordnung der elektrischen Antriebsvorrichtung 6 muss nicht bereitgestellt werden, wobei zudem die Energieversorgung für das bewegbare Möbelteil 2 sowie eine hinreichende Bewegungsübertragung auf das bewegbare Möbelteil 2 erleichtert wird.

Damit verbunden ist ein zweiter (über einen Synergieeffekt der technischen Wirkungen verbundener) Aspekt, welcher eine komfortable sowie (insbesondere im Sinne von zur Verfügung stehendem Stauraum) ressourcensparende Anbringung der elektrischen Antriebsvorrichtung 6 betrifft, wobei - insbesondere über die Anbindung an der Korpusschiene 4 und/oder durch eine zweckdienliche Getriebeausgestaltung und/oder Wahl des Elektromotors 7 - die elektrische Antriebsvorrichtung 6 in kompakter beziehungsweise schmaler Ausführung unterhalb des bewegbaren Möbelteiles 2 lokalisiert werden kann. Dadurch kann eine Tiefe des feststehenden Möbelteiles 1 optimal ausgenutzt werden und eine bewegbare Stromversorgung ist nicht erforderlich.

Fig. 7b unterscheidet sich von Fig. 7a lediglich dahingehend, dass die elektrische Antriebsvorrichtung 6 in perspektivischer Ansicht dargestellt ist.

Der Elektromotor 7 ist innerhalb eines Gehäuses 47 mit einer Dicke 67 in vertikaler Richtung 15 in Gebrauchsstellung 14 der Anordnung unterhalb von 100 mm angeordnet. Es ist möglich, Dicken 67 unterhalb von 80 mm zu bewerkstelligen. Die Dicke 67 liegt bevorzugt unterhalb von 60 mm (und ist auch unterhalb von 40 mm denkbar), sodass bei herkömmlichen Möbeln eine Möbelteilfront 23 unter die Unterseite der elektrischen Antriebsvorrichtung 6 ragt.

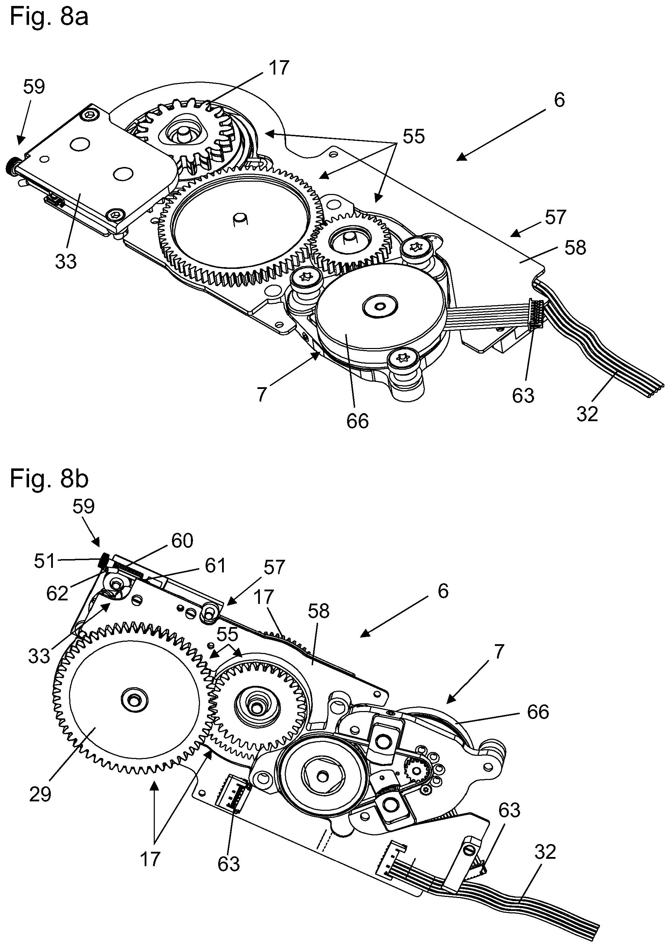

Fig. 8a zeigt, dass der Elektromotor 7 der elektrischen Antriebsvorrichtung 6 in Form eines bürstenlosen Außenläufermotors 66 vorliegt, wobei im Allgemeinen auch bürstenbehaftete Außenläufermotoren 66, Scheibenläufermotoren oder Stabmotoren vorgesehen sein können. Außenläufermotoren und Scheibenläufermotoren weisen eine besonders flache Bauweise auf und sind daher bevorzugt.

Der Elektromotor 7 ist an eine Vielzahl an Getriebestufen 55 mit Zahnrädern 17 zum Antrieb des bewegbaren Möbelteiles 2 angebunden. Über eine Konfiguration der Getriebestufen 55 kann eine Dicke 67 weiter reduziert und auch die weiteren Dimensionierungen kompakt ausgeführt werden.

Fig. 8b unterscheidet sich von Fig. 8 lediglich dahingehend, dass die in Wirkverbindung mit dem Elektromotor 7 stehenden Bauteilkomponenten der elektrischen Antriebsvorrichtung 6 aus einem geänderten Blickwinkel betrachtet werden.

Die elektrische Antriebsvorrichtung 6 umfasst eine Datenschnittstelle 63 zur kabelgebundenen Übermittlung zumindest eines in einer Speichereinheit hinterlegten digitalen Datensatzes, wobei die Datenschnittstelle 63 im Allgemeinen alternativ oder in Ergänzung zur funksignalübertragenden Übermittlung des digitalen Datensatzes ausgestaltet sein kann.

Die elektrische Antriebsvorrichtung 6 umfasst einen Auslösesensor 59 zur Aktivierung des Elektromotors 7 für eine Schließstellung des bewegbaren Möbelteiles 2, wobei die elektrische Antriebsvorrichtung 6 ein in der Darstellung demontiertes Gehäuse 47 aufweist und der Auslösesensor 59 an dem Gehäuse 47 zur Kontaktierung des bewegbaren Möbelteiles 2 in Gebrauchsstellung 14 der elektrischen Antriebsvorrichtung 6 angeordnet ist.

Der Auslösesensor 59 umfasst einen Stößel 60 und einen Mikroschalter 61, welcher taktil und elektronisch über den Mikroschalter 61 auslösbar ist. Ein ausschließlich elektronisch betätigbarer Auslösesensor 59 kann alternativ oder in Ergänzung vorgesehen sein.

Fig. 9 zeigt eine Wegmesseinrichtung 33 für die Anordnung, wobei die Wegmesseinrichtung 33 zur Bestimmung einer Position des bewegbaren Möbelteiles 2 relativ zu dem feststehenden Möbelteil 1 ausgebildet ist und durch die Wegmesseinrichtung 33 die Position in Form eines zurückgelegten Absolutweges des bewegbaren Möbelteiles 2 gegenüber dem feststehenden Möbelteiles 1 eindeutig ermittelbar ist.

Die elektrische Antriebsvorrichtung 6 umfasst einen mit 230 V versorgbaren Elektromotor 7 zur zumindest bereichsweise automatisierten Bewegung des bewegbaren Möbelteiles 2 relativ zu dem feststehenden Möbelteil 1, wobei die Wegmesseinrichtung 33 an der elektrischen Antriebsvorrichtung 6 angeordnet ist beziehungsweise einen integralen Bestandteil der Antriebsvorrichtung 6 in Wechselwirkung mit dem Elektromotor 7 darstellt sowie in dem Gehäuse 47 der elektrischen Antriebsvorrichtung 6 integriert ist. Eine Anordnung innerhalb des Gehäuses 47 ist jedoch nicht zwingend erforderlich.

Das bewegbare Möbelteil 2 ist entlang der Führungsvorrichtung 3 relativ zu dem feststehenden Möbelteil 1 über die Wegstrecke 13 zwischen der Schließstellung und der Öffnungsstellung 30 translatorisch bewegbar und über die gesamte Wegstrecke 13 durch die elektrische Antriebsvorrichtung 6 antreibbar. Die Wegmesseinrichtung 33 ist zur Bestimmung einer Position des bewegbaren Möbelteiles 2 relativ zu dem feststehenden Möbelteil 1 vorgesehen, wobei eine relative Stellung über die Wegmesseinrichtung 33 eindeutig ermittelbar ist.

Die Wegmesseinrichtung 33 umfasst zur Bestimmung der Position Potentiometer 49 in Form von Drehpotentiometer, wobei sich in der zugrundeliegenden Elektronik Hall-Sensoren (Magnet in Verbindung mit Hall-Elektronik) als besonders günstig erwiesen haben. Alternativ oder in Ergänzung kann eine Distanzsensorik 50 - beispielsweise ein Distanzlaser - vorgesehen sein. Die Distanzsensorik 50 kann im Allgemeinen auch räumlich von der elektrischen Antriebsvorrichtung 6 beabstandet lokalisiert sein. Die Wegmesseinrichtung 33 ist an der elektrischen Antriebsvorrichtung 6 angeordnet.

Der Absolutweg wird ausgehend von einer vordefinierten Referenzposition aus bestimmt, wobei die Referenzposition in Form einer Relativstellung zwischen dem bewegbaren Möbelteil 2 und dem feststehenden Möbelteil 1 - in diesem Ausführungsbeispiel als Anschlag 51 für die Erkennung einer Endlage des bewegbaren Möbelteiles 2 gegeben - oder einer Referenzstellung der elektrischen Antriebsvorrichtung 6 - in dieser Ausführungsform als eine Ausgangsstellung der Zahnräder 17 in Verbindung mit dem Elektromotors 7 gegeben - vorliegt.

Es ist eine Geschwindigkeitsmesseinrichtung 52 in Form eines an dem Elektromotor 7 angeordneten Potentiometers 49 oder integriert in einer Steuerungs- und/oder Regelungsreinrichtung 44 oder einem Mikrokontroller 35 vorgesehen. Die Geschwindigkeitsmesseinrichtung 52 wird zur Bestimmung einer Geschwindigkeit des bewegbaren Möbelteiles 2 relativ zu dem feststehenden Möbelteil 1 genutzt, wobei das bewegbare Möbelteil 2 durch die elektrische Antriebsvorrichtung 6 mit einem an die ermittelte Geschwindigkeit des bewegbaren Möbelteiles 2 und/oder den ermittelten Absolutweg angepassten Geschwindigkeitsprofil angetrieben werden kann.

Die Steuerungs- und/oder Regelungseinrichtung 44 oder der Mikrokontroller 37 kann herangezogen werden, um den Elektromotor 7 bei einer vordefinierten und durch die Geschwindigkeitsmesseinrichtung 52 ermittelten Geschwindigkeit oder bei einem vordefinierten und durch die wenigstens eine Wegmesseinrichtung 33 ermittelten Absolutweg zu aktivieren.

Die Position in Form des zurückgelegten Absolutweges wird als dynamischer Datensatz und die Geschwindigkeit als dynamischer Datensatz zur Simulation des Modelles über die Recheneinheit des Mikrokontrollers 37 oder der Steuerungs- und/oder Regelungseinheit 44 zumindest temporär der Speichereinheit hinterlegt.

Die Wegmesseinrichtung 33 umfasst einen ersten Positionssensor 53 in Form Sensorrades als Zahnrad 17 ausgebildet und einen weiteren Positionssensor 54 in Form eines weiteren Sensorrades als Zahnrad 17 ausgebildet, wobei der Absolutweg über eine relative Rotationsstellung der Positionssensoren 53, 54 eindeutig bestimmtbar ist.

Der erste Positionssensor 53 und der weitere Positionssensor 54 liegen in Form von Getriebestufen 55 der elektrischen Antriebsvorrichtung 6 vor, wobei diese Getriebestufen 55 nicht für eine Übersetzung des Antriebes von dem Elektromotor 7 auf die Ladenschiene 5 erforderlich sind; hierzu werden weitere Getriebestufen 55 herangezogen. Über das erste Sensorrad ist ein für die Wegmesseinrichtung 33 nutzbares Übersetzungsverhältnis im Bereich zwischen 1,01:1 und 1,2:1 vermittelbar. Zwischen dem ersten Sensorrad und dem weiteren Sensorrad ist ein Übersetzungsverhältnis im Bereich zwischen 1,2:1 und 2,3:1, und über das erste Sensorrad und das weitere Sensorrad ein Übersetzungsverhältnis im Bereich zwischen 1,5:1 und 2:1 vermittelbar.

Die Sensorräder als Positionssensoren 53, 54 sind als Zahnräder 17 ausgebildet, welche jedoch nicht für den Eingriff der elektrischen Antriebsvorrichtung 6 in die Zahnstange 9 erforderlich sind. Der Durchmesser 56 des ersten Sensorrades weicht von einem Durchmesser 56 des zweiten Sensorrades ab, wobei durch die Wegmesseinrichtung 33 ein Absolutweg bis 1200 mm eindeutig bestimmbar ist.

Der Absolutweg des bewegbaren Möbelteiles 2 wird ausgehend von einer Referenzstellung über eine Summe oder eine Differenz aus Drehwinkeln der beiden Positionssensoren 53, 54 bestimmt, sodass eine Distanzierung zwischen dem bewegbaren Möbelteil 2 und dem feststehenden Möbelteil 1 eindeutig berechenbar ist.

Die Wegmesseinrichtung 33 umfasst eine Magnetlagerung 57 über das Gehäuse 47 der elektrischen Antriebsvorrichtung 6 und ein Kunststoffteil 58. Das Kunststoffteil 58 agiert als Doppelfunktion als Platine für einen Mikrokontroller 37.

Die Wegmesseinrichtung 33 umfasst einen taktilen Auslösesensor 59 in Form eines Stößels 60 und eines Mikroschalters 61, wobei im Allgemeinen auch anderweitige Auslösesensoren 59 vorgesehen sein können, welche keine mechanische Auslösung erfordern, sodass ein Frontspalt zwischen dem bewegbaren Möbelteil 2 und dem feststehenden Möbelteil 1 in Schließstellung für eine Überdrückbewegung zur elektronischen Auslösung entfallen kann, wodurch ein Möbel mit einem ästhetisch besonders ansprechendem Erscheinungsbild erwirkt werden kann. Eine rein elektronische Auslösung kann beispielsweise durch Kontaktierung des bewegbaren Möbelteiles 2 erfolgen, wobei beispielsweise ein Drücken oder Wischen eines Benutzers des bewegbaren Möbelteiles an einer Möbelteilfront 23 detektiert wird.

Die Wegmesseinrichtung 33 ist zusammen mit der elektrische Antriebsvorrichtung 6 stationär an der Korpusschiene 4 angeordnet, wobei eine Bewegungsübertragung der elektrischen Antriebsenergie auf die an der Ladenschiene 5 angeordneten Zahnstange 9 erfolgt, um eine Kraftübertragung über die gesamte Wegstrecke 13 oder ausgehend von einem beliebigen Punkt entlang der Wegstrecke 13 über einen Teilbereich der Wegstrecke 13 vermitteln zu können.

Die Wegmesseinrichtung 33 ist in Gebrauchsstellung 14 der Anordnung vollständig unterhalb des bewegbaren Möbelteiles 2 mittelbar über die elektrische Antriebsvorrichtung 6 an der Korpusschiene 4 angeordnet. Gegebenenfalls kann eine Möbelteilfront 23 des bewegbaren Möbelteiles 2 unter die elektrischen Antriebsvorrichtung 6 oder die Wegmesseinrichtung 33 ragen, um beispielsweise den Auslösesensor 59 zu kontaktieren. Zumindest ein Boden des bewegbaren Möbelteiles 2 ist jedoch oberhalb der elektrischen Antriebsvorrichtung 6 angeordnet.

Beide Zahnräder 17 für die Positions- oder Geschwindigkeitsbestimmung weisen einen Mikrochip auf. Ein weiteres Zahnrad 17 überträgt die Energie des Elektromotors 7 auf die Zahnstange 9.

Die elektrische Antriebsvorrichtung 6 ist zumindest abseits einer Schließstellung des bewegbaren Möbelteiles 2 kontaktlos zu dem bewegbaren Möbelteil 2 an der Führungsvorrichtung 3 angeordnet.

Anhand Fig. 10 wird ein exemplarisches Verfahren zum Bewegen des bewegbaren Möbelteiles 2 relativ zu dem Möbelteil 1 zumindest bereichsweise entlang der Wegstrecke 13 des bewegbaren Möbelteiles 2 zwischen einer Schließstellung und einer partiellen oder vollständigen Öffnungsstellung 30 des bewegbaren Möbelteiles 2 durch die elektrische Antriebsvorrichtung 6 und einer Wegmesseinrichtung 33 expliziert: Über die Wegmesseinrichtung 33 wird eine Position des bewegbaren Möbelteiles 2 relativ zu dem feststehenden Möbelteil 1 als zurückgelegter Absolutweg des bewegbaren Möbelteiles 2 gegenüber dem feststehenden Möbelteil 1 eindeutig bestimmt und das bewegbare Möbelteil 2 wird durch die elektrische Antriebsvorrichtung 6 zwischen der Schließstellung und der Öffnungsstellung 30 entlang der Führungsvorrichtung 3 über einen Teilbereich der Wegstrecke 13 in Abhängigkeit des durch die Wegmesseinrichtung 33 ermittelten Absolutweges translatorisch bewegt. Ein Antrieb der Ladenschiene 5 über die gesamte Wegstrecke 13 ist durch die stetige Kopplung zwischen Zahnstange 9 und elektrischer Antriebsvorrichtung 6 im Allgemeinen möglich, jedoch nicht zwingend erforderlich.

Im Verfahren kann der Absolutweg ausgehend von einer vordefinierten Referenzposition aus, über eine relative Stellung der Positionssensoren 53, 54 sowie ausgehend von einer Referenzstellung über eine Summe oder Differenz aus Drehwinkeln der Positionssensoren 53, 54 als Distanzierung zwischen dem bewegbaren Möbelteil 2 (im Allgemeinen der Ladenschiene 5) und dem feststehenden Möbelteil 1 (im Allgemeinen der Korpusschiene 4) eindeutig ermittelt werden.

Über eine Steuerungs- und/oder Regelungseinrichtung 44 oder einen Mikrokontroller 37 kann das bewegbare Möbelteil 2 mit einem an die ermittelte Geschwindigkeit oder den ermittelten Absolutweg angepassten Geschwindigkeitsprofil angetrieben werden, wobei die elektrische Antriebsvorrichtung 6 bei einer vordefinierten Geschwindigkeit oder bei einem vordefinierten Absolutweg aktiviert wird. Beispielsweise kann ein Algorithmus oder ein Computerprogrammprodukt hinterlegt sein, welcher/welches Befehle umfasst, die bei einer Ausführung durch eine Recheneinheit diese veranlassen, aus einer Speichereinheit, welche mit der Recheneinheit in einer Datenverbindung steht, das Verfahren auszuführen.

Durch die Wegmesseinrichtung 33 und insbesondere durch die eindeutig bestimmbare relative Stellung zwischen feststehendem Möbelteil 1 beziehungsweise Korpusschiene 4 und bewegbarem Möbelteil 2 beziehungsweise Ladenschiene 5 kann gewährleistet werden, dass selbst nach einem Stromausfall oder einer anderweitigen Störung eindeutig ermittelt werden kann, an welcher Position sich das bewegbare Möbelteil 2 entlang der Wegstrecke 13 der Führungsvorrichtung 3 befindet. Der zurückgelegte Absolutweg kann ohne Referenzfahrt eindeutig berechnet werden, wodurch ein sachgemäßer Betrieb und insbesondere ein an die Position abgestimmter Antrieb in besonders störungsresistenter Art und Weise gewährleistbar ist.

Darüber hinaus kann über die bestimmte Position eine sachgemäße Erkennung, ob das bewegbare Möbelteil 2 durch die elektrische Antriebsvorrichtung 6 mit Kraft in Richtung der Schließstellung oder der Öffnungsstellung 30 beaufschlagt werden soll, sichergestellt werden. Beispielsweise kann anhand der Position und gegebenenfalls über die Geschwindigkeit festgestellt werden, ob der Benutzer des bewegbaren Möbelteiles 2 das bewegbare Möbelteil 2 in einem Freilaufbereich bewegen will oder einen Antrieb in Schließrichtung oder Öffnungsrichtung wünscht. Zudem kann ein auf das bewegbare Möbelteil 2 zu übertragenes Geschwindigkeitsprofil angepasst werden, sodass eine individuelle Geschwindigkeit für jedwede Position entlang der Führungsvorrichtung individuell vermittelt werden kann. Die Position kann eine zusätzliche Information bereitstellen, ob das bewegbare Möbelteil 2 in dem Freilaufbereich (gegebenenfalls bidirektional) frei beweglich oder über die elektrische Antriebsvorrichtung (in Schließrichtung oder Öffnungsrichtung) angetrieben werden soll sowie in welchem Maß die Kraftbeaufschlagung erfolgen beziehungsweise mit welchem Geschwindigkeitsprofil das bewegbare Möbelteil 2 bewegt werden soll.

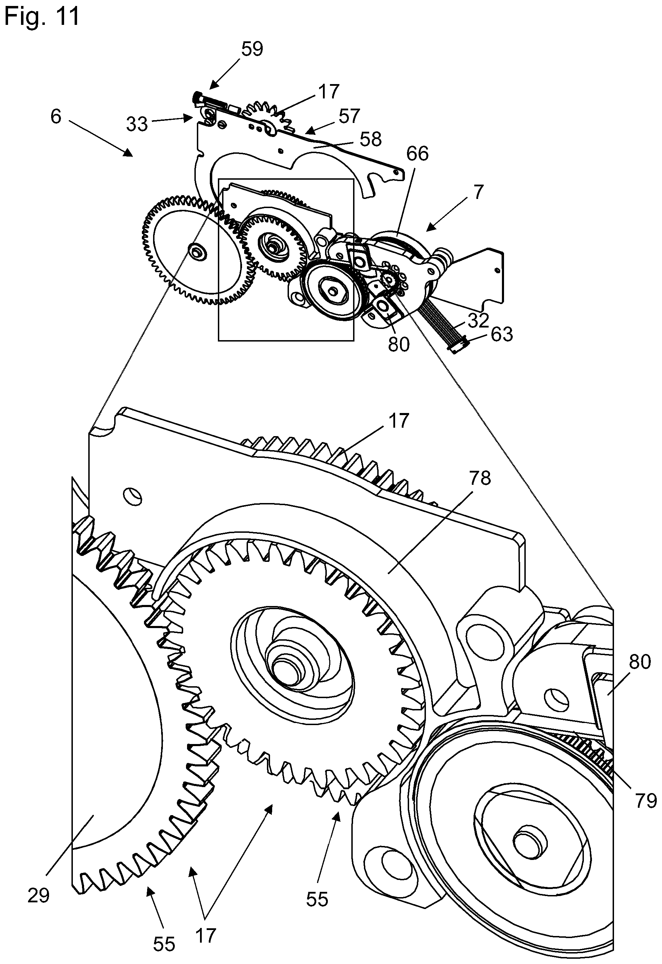

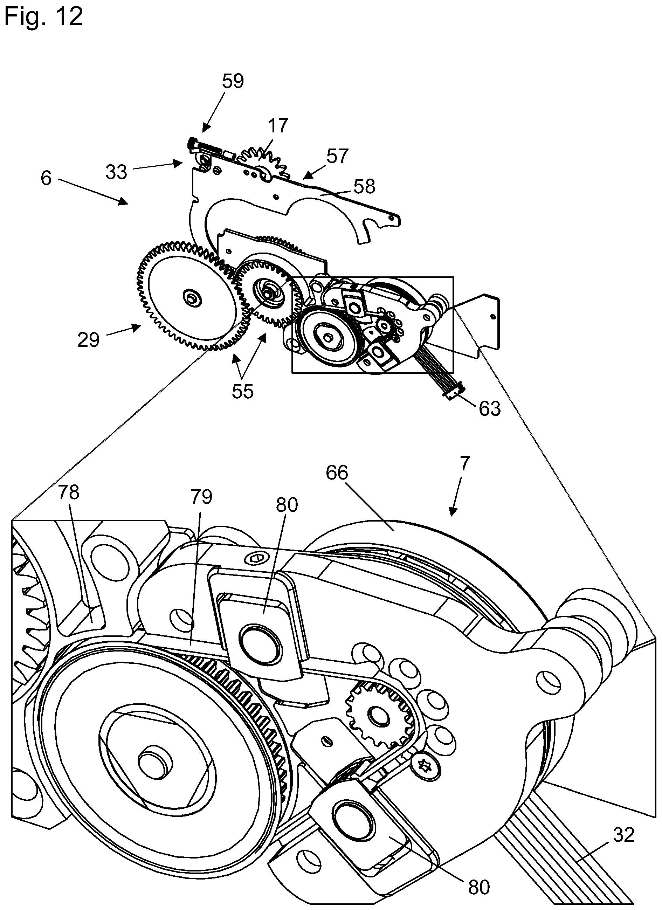

Fig. 11 und Fig. 12 zeigen Bauteilkomponenten der elektrischen Antriebsvorrichtung 6, wobei in Fig. 11 in dem vergrößerten Detailausschnitt ein in dem Gehäuse 47 integrierter Schutzkörper 78 ersichtlich ist, welcher das Getriebe - insbesondere eine Getriebestufe 55 - vor einem Abrieb durch einen Riemen (Antriebsriemen 79) schützt.

In Fig. 12 ist der Riemenantrieb in Verbindung mit dem Elektromotor 7 vergrößert dargestellt, wobei zwei Riemenspanner 80 vorgesehen sind, welche eine für den Antrieb der elektrischen Antriebsvorrichtung 6 günstigen Spannung vermitteln. Im Allgemeinen kann auch lediglich ein Riemenspanner 80 oder mehrere Riemenspanner 80 vorgesehen sein, wobei sich zwei an gegenüberliegenden Seiten des Antriebsriemen 79 angeordnete Riemenspanner 80 als besonders vorteilhaft erwiesen haben.

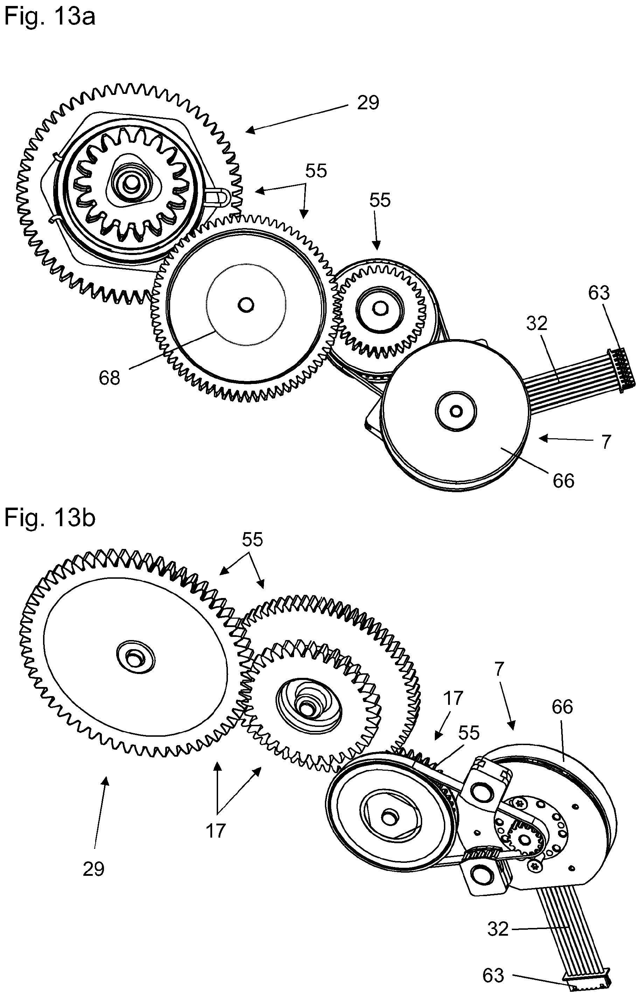

Fig. 13a zeigt die Getriebestufen 55 des Elektromotor 7, wobei der Elektromotor 7 mit einer Freilaufkupplung 29 gekoppelt ist.

Der Elektromotor 7 kann im Allgemeinen eine Überlastkupplung 68 umfassen, welche lediglich schematisch durch eine punktierte Linie angedeutet ist, da diese nicht zwingend als eigene Bauteilkomponente erforderlich ist.

Fig. 13b unterscheidet sich von Fig. 13a lediglich durch eine Ansicht aus geänderter Blickrichtung.

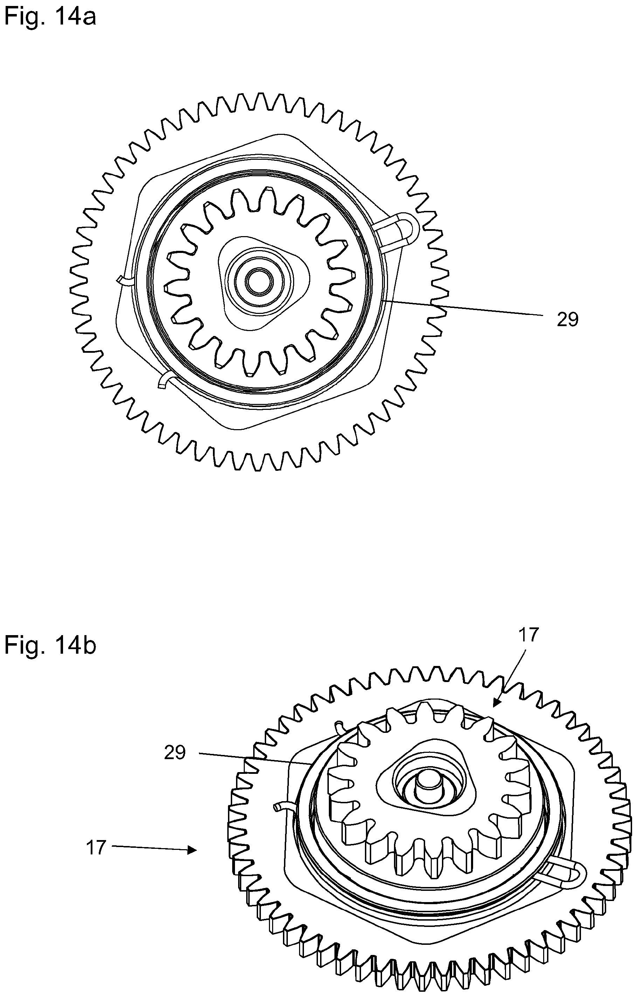

Fig. 14a und Fig. 14b zeigen eine Freilaufkupplung 29 als Bauteilkomponente umfassend zwei Zahnräder 17, welche als Getriebestufen 55 agieren können. Die Freilaufkupplung 29 ist im Allgemeinen nicht selbsthemmend.

Technische Details zu einer derartigen Freilaufkupplung 29 - insbesondere Schlingfederfreilaufkupplung - können der EP 2 086 372 B2 entnommen werden.

Da die Freilaufkupplung 29 in der elektrischen Antriebsvorrichtung 6 integriert ist, kann die Freilaufkupplung 29 stationär an der Korpusschiene 4 verortet bleiben.

Konkret umfasst die elektrische Antriebsvorrichtung 6 die Freilaufkupplung 29, mit welcher das bewegbare Möbelteil 2 in Schließrichtung und in Öffnungsrichtung - beispielsweise in Abhängigkeit einer Geschwindigkeit des bewegbaren Möbelteiles 2 oder einer Position des bewegbaren Möbelteiles 2 - entlang der Wegstrecke 13 von einem Antrieb über den Elektromotor 7 entkoppelbar ist. Durch die Freilaufkupplung 29 kann das bewegbare Möbelteil 2 zwischen einer Öffnungsstellung 30 und einer Schließstellung - zum Beispiel in Abhängigkeit einer Kraftausübung auf das bewegbare Möbelteil 2 - in einem Feilaufbereich entkoppelt von einem Antrieb durch die elektrische Antriebsvorrichtung 6 bewegbar werden oder über die Wegstrecke 13 (im Allgemeinen Teilbereiche der Wegstrecke 13) durch die elektrische Antriebsvorrichtung 6 angetrieben werden.

Eine Überlastkupplung 68 kann im Allgemeinen ebenfalls vorgesehen sein, welche - beispielsweise in Abhängigkeit einer Geschwindigkeit des bewegbaren Möbelteiles 2 oder einer Position des bewegbaren Möbelteiles 2 - eine Entkopplung zwischen dem Elektromotor 7 und der Zahnstange 9 ermöglicht; durch eine doppelt lösbare Verbindung der Zahnstange 9 (lösbare Verbindung zwischen Trägereinrichtung 10 und Zahnstange 9 sowie Zuzieheinrichtung 8) während des Eingriffs des Zahnrades 17 der elektrischen Antriebsvorrichtung 6 in der Funktion als Überlastkupplung 68 kann auf eine integrierte Überlastkupplung 68 verzichtet werden. Im Allgemeinen kann es ausreichend sein, dass lediglich die Zahnstange 9 lösbar an der Trägereinrichtung 10 oder lediglich die Trägereinrichtung 10 lösbar an der Zuzieheinrichtung 8 angeordnet ist.

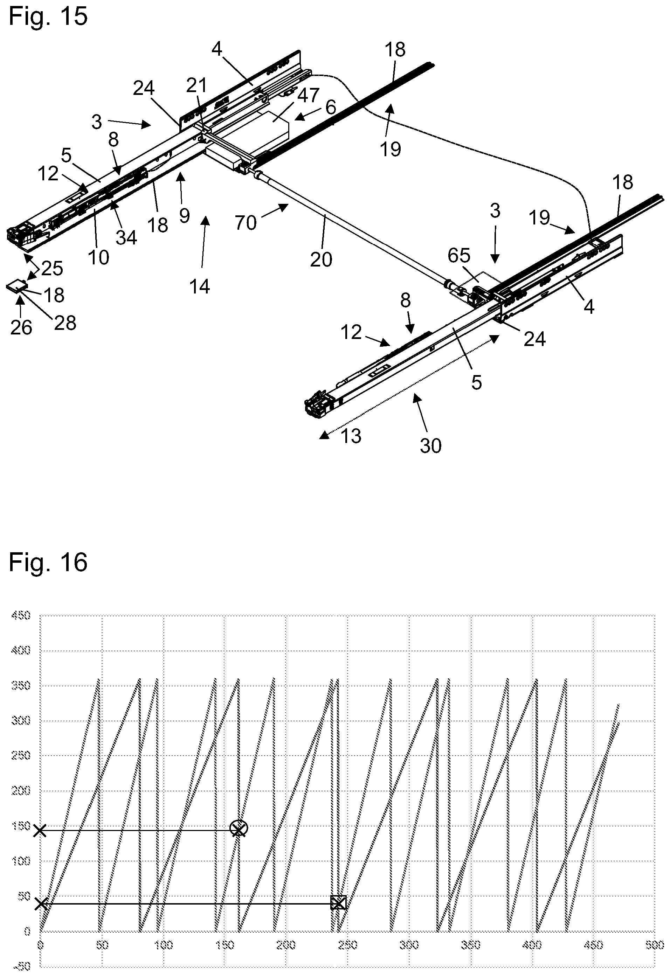

Fig. 15 zeigt eine einseitig an der Führungsvorrichtung 3 angeordnete elektrische Antriebsvorrichtung 6, wobei ein weiterer Auslösesensor 65 (schematisch durch punktierte Linien angedeutet) zur Aktivierung des Elektromotors 7 für eine Schließstellung (Aktivierung in beziehungsweise über die Schließstellung oder gegebenenfalls einer Überdrückstellung) eines an dem feststehenden Möbelteil 1 angeordneten bewegbaren Möbelteiles 2 stationär an der zweiten Möbelplatte 64 über die an der zweiten Möbelplatte 64 angeordneten Korpusschiene 4 angeordnet ist.

Der weitere Auslösesensor 65 umfasst bevorzugt eine Dämpfvorrichtung 12 oder einen Puffer. Der weitere Auslösesensor 65 kann über eine Funkverbindung oder eine Kabelverbindung mit der elektrischen Antriebsvorrichtung 6 in Datenverbindung stehen. Durch den weiteren Auslösesensor 65 kann eine Bearbeitung der Möbelteilfront 23 entfallen. Bevorzugt wird der weitere Auslösesensor 65 mit dem Auslösesensor 59 zusammen.

Die Anordnung umfasst eine Stabilisierungseinrichtung 70 zur Seitenstabilisierung des bewegbaren Möbelteiles 2 entlang der Führungsvorrichtung 3. Im Allgemeinen kann eine hinreichende Seitenstabilisierung über das bewegbare Möbelteil 2 an sich generiert werden. Es ist denkbar, die Stabilisierungseinrichtung 70 an der zweiten Schnittstelle 35 (siehe Fig. 7a) anzubinden.

An der Führungsvorrichtung 3 sind zwei weitere Zahnstangen 19 angeordnet, welche an den zwei Korpusschienen 4 angeordnet sind, wobei eine Synchronisationsstange 20 zwischen den zwei weiteren Zahnstangen 19 zur Seitenstabilisierung an den zwei weiteren Zahnstangen 19 angeordnet ist. Die Verzahnung 18 der weiteren Zahnstangen 19 ist in vertikaler Richtung 15 nach oben hin ausgerichtet und steht orthogonal zu einer Ausrichtung der Verzahnung der Zahnstange 9, wobei dies nicht zwingend erforderlich ist.

Die Synchronisationsstange 20 mit den beiden weiteren Zahnstangen 19 kann als gesonderte Konfiguration als Add-On vorgesehen sein, wobei zumindest eine der drei Bauteilkomponenten an der zweiten Schnittstelle 35, der Zahnstange 9, der Korpusschiene 4 oder der elektrischen Antriebsvorrichtung 6 angebunden sein kann.

Zwischen den beiden Korpusschienen 4 besteht eine direkte Stromverbindung (schematisch durch eine strichlierte Linie dargestellt). Eine Stromleitung 32 für den Elektromotor 7 kann über die Korpusschiene 4 oder die Zahnstange 9 - beispielsweise zur Energieversorgung einer Ausstoßeinrichtung 11 - geführt sein.

Links in der Darstellung ist schematisch angedeutet, dass die Zahnstange 9 eine Kopplungseinrichtung 25 umfassen kann, mit welcher die Zahnstange 9 durch eine Zahnstangenverlängerung 26 verlängerbar ist, wobei die Zahnstange 9 anschließend in Längsrichtung 27 aus zumindest zwei Zahnstangensegmenten 28 zusammengesetzt ist. Dadurch kann eine längenverstellbare Zahnstange 9 bereitgestellt werden, um eine Dimensionierung der Zahnstange 9 individuell an eine Dimensionierung der Führungsvorrichtung 3 oder einem Auszugsweg entlang der Wegstrecke 13 adjustieren zu können. Im Allgemeinen ist auch denkbar, die Zahnstange 9 teleskopierbar auszubilden.

Fig. 16 zeigt ein Diagramm mit auf der Ordinate aufgetragenen Sensorwinkeln (in Grad) und auf der Abszisse aufgetragenen Absolutwegen entlang der Wegstrecke 13 (in mm). Über die beiden Positionssensoren 53, 54 ist die Position der Ladenschiene 5 beziehungsweise des bewegbaren Möbelteiles 2 eindeutig entlang der Wegstrecke 13 durch die relative Rotationsstellung identifzierbar.

Im Diagramm ist ein Schnittpunkt der Sensorwinkel entsprechend einer Auszugslänge von circa 245 mm mit einem Quadrat gekennzeichnet, wobei dieser Schnittpunkt drei vollständigen Rotationen des ersten Positionssensors 53 und fünf vollständigen Rotationen des zweiten Positionssensors 54 entspricht. Die Differenz der Rotationswinkel entspricht 36°, wodurch die Position eindeutig definiert ist. Ein weiterer Schnittpunkt der Sensorwinkel entsprechend eines Absolutweges von circa 165 mm ist mit einem Kreis gekennzeichnet, wobei dieser Schnittpunkt zwei vollständigen Umdrehungen des ersten Positionssensors 53 und fünf vollständigen Umdrehungen des zweiten Positionssensors 54 entspricht. Die Differenz der Rotationswinkel entspricht 144°, sodass die Position eindeutig definiert ist.

In diesem Ausführungsbeispiel ist eine Signaltoleranz des ersten Positionssensors 53 bezogen auf eine maximale Anzahl an sechs Rotationen für eine eindeutige Positionsbestimmungen gleich 60°. Analog ist eine Signaltoleranz für den zweiten Positionssensor 54 bezogen auf maximal 10 Umdrehungen gleich 36°. Kombiniert kann eine Toleranz auf +/- 30° für den ersten Positionssensor 53 und +/- 18° für den zweiten Positionssensor 54 reduziert werden, welche hinreichend exakt für eine präzise Bestimmung des Absolutweges über beide Positionssensoren 53, 54 ist. Bei gegebener Übersetzung kann gegebenenfalls bei langen Wegstrecken 13 eine Redundanz an Schnittpunkten für die Ermittlung des Absolutweges auftreten, wobei dieser unerwünschte Sachverhalt durch einen Eintrag in einer Speichereinheit oder einer variierenden Übersetzung ausgeräumt werden kann. Auch ist denkbar, eine ergänzende Sensorik heranzuziehen.

## Patentansprüche

1. Anordnung umfassend
- ein feststehendes Möbelteil (1), insbesondere Möbelkorpus,
- ein relativ zu dem feststehenden Möbelteil (1) bewegbares Möbelteil (2), insbesondere Schublade,
- eine Führungsvorrichtung (3), insbesondere Schubladenausziehführung, zur Führung des bewegbaren Möbelteiles (2) relativ zu dem feststehenden Möbelteil (1), mit wenigstens einer Korpusschiene (4) und wenigstens einer relativ zu der wenigstens einen Korpusschiene (4) verschiebbaren Ladenschiene (5) und
- wenigstens eine elektrische Antriebsvorrichtung (6) zur zumindest bereichsweise automatisierten Bewegung des bewegbaren Möbelteiles (2) relativ zu dem feststehenden Möbelteil (1) umfassend einen, insbesondere mit 230 V versorgbaren, Elektromotor (7),
wobei wenigstens eine Zuzieheinrichtung (8) für das bewegbare Möbelteil (2) und wenigstens eine in Wirkverbindung mit der wenigstens einen elektrischen Antriebsvorrichtung (6) stehende Zahnstange (9) vorgesehen sind, wobei die wenigstens eine Zuzieheinrichtung (8), vorzugsweise unmittelbar, an der wenigstens einen Ladenschiene (5) angeordnet ist und die wenigstens eine Zahnstange (9), vorzugsweise mittelbar, an der wenigstens einen Ladenschiene (5) angeordnet ist, **dadurch gekennzeichnet, dass** die wenigstens eine Zahnstange (9) lösbar an wenigstens einer Trägereinrichtung (10) angeordnet ist und/oder wenigstens eine Trägereinrichtung (10) für die Zahnstange (9) lösbar an der wenigstens einen Zuzieheinrichtung (8) angeordnet ist.

2. Anordnung nach Anspruch 1, wobei
- die wenigstens eine, vorzugsweise genau eine, Trägervorrichtung (10) zumindest bereichsweise zwischen der wenigstens einen Zahnstange (9) und der wenigstens einen Zuzieheinrichtung (8) angeordnet ist und/oder
- die wenigstens eine Trägereinrichtung (10) und/oder die wenigstens eine Zuzieheinrichtung (8) wenigstens eine, vorzugsweise mechanische, Ausstoßeinrichtung (11) und/oder wenigstens eine Dämpfvorrichtung (12) umfasst.

3. Anordnung nach einem der vorangehenden Ansprüche, wobei
- die wenigstens eine elektrische Antriebsvorrichtung (6) stationär an der wenigstens einen Korpusschiene (4) angeordnet ist und über eine gesamte Wegstrecke (13) für das bewegbare Möbelteil (2) entlang der Führungsvorrichtung (3) in stetiger Verbindung zu der wenigstens einen Zahnstange (9) zur Bewegungsübertragung steht, wobei vorzugsweise vorgesehen ist, dass die elektrische Antriebsvorrichtung (6) ein mit der wenigstens einen Zahnstange (9) kämmendes, besonders bevorzugt in Gebrauchsstellung (14) der Anordnung in vertikaler Richtung (15) nach oben oder in horizontaler Richtung (16) in Richtung der wenigstens einen Ladenschiene (5) weisendes, Zahnrad (17) umfasst, und/oder
- die wenigstens eine Zahnstange (9) zumindest bereichsweise zwischen der wenigstens einen elektrischen Antriebsvorrichtung (6) und der wenigstens einen Ladenschiene (5) angeordnet ist.

4. Anordnung nach einem der vorangehenden Ansprüche, wobei die Führungsvorrichtung (3) zur Bewegung des bewegbaren Möbelteiles (2) zwei an zwei Korpusschienen (4) angeordnete Ladenschienen (5) umfasst, wobei genau eine elektrische Antriebsvorrichtung (6) an einer der beiden Korpusschienen (4) und/oder genau eine Zahnstange (9) an einer der beiden Ladenschienen (5) angeordnet ist.

5. Anordnung nach einem der vorangehenden Ansprüche, wobei eine Stromversorgung der wenigstens einen elektrischen Antriebsvorrichtung (6) oder einer gegebenenfalls vorhandenen weiteren Stromsenke über die wenigstens eine Korpusschiene (4) und/oder über die wenigstens eine Zahnstange (9), vorzugsweise mit einer Stromverbindung zwischen zwei Korpusschienen (4) und/oder zwei Zahnstangen (9), geführt ist.

6. Anordnung nach einem der vorangehenden Ansprüche, wobei eine Verzahnung (18) der wenigstens einen Zahnstange (9) in Gebrauchsstellung (14) der Anordnung in vertikaler Richtung (15) nach unten oder in horizontaler Richtung (16) in eine von der wenigstens einen Ladenschiene (5) wegweisenden Richtung orientiert ist, wobei vorzugsweise vorgesehen ist, dass die wenigstens eine Zahnstange (9) mit einem Zahnrad (17) der wenigstens einen elektrischen Antriebsvorrichtung (6) gekoppelt ist, wobei
- die wenigstens eine Zahnstange (9) bei einer vertikal ausgerichteten Verzahnung (18) in horizontaler Richtung (16) und/oder in vertikaler Richtung (15) in Richtung der wenigstens einen Ladenschiene (5), besonders bevorzugt gegenüber der wenigstens einen Trägervorrichtung (10), um eine gedachte Achse verschwenkbar oder verbiegbar und damit begrenzt seitlich und/oder vertikal beweglich gelagert ist oder
- die wenigstens eine Zahnstange (9) bei einer horizontal ausgerichteten Verzahnung (18) in vertikaler Richtung (15) nach unten und/oder in horizontaler Richtung (16), besonders bevorzugt gegenüber der wenigstens einen Trägervorrichtung (10), um eine gedachte Achse verschwenkbar oder verbiegbar und damit begrenzt vertikal und/oder seitlich beweglich gelagert ist.

7. Anordnung nach einem der vorangehenden Ansprüche, wobei
- die Führungsvorrichtung (3) zwei Korpusschienen (4) und zwei relativ zu den Korpusschienen (4) verschiebbare Ladenschienen (5) umfasst, wobei zwei weitere Zahnstangen (19) vorgesehen sind, welche an den zwei Korpusschienen (4) und/oder den zwei Ladenschienen (5) angeordnet sind, wobei eine Synchronisationsstange (20) zwischen den zwei weiteren Zahnstangen (19) zur Seitenstabilisierung an den zwei weiteren Zahnstangen (19) angeordnet ist, und/oder
- wenigstens eine Lagervorrichtung (21) für die wenigstens eine Zahnstange (9) an der wenigstens einen Ladenschiene (5) und der wenigstens einen Zahnstange (9) angeordnet ist, wobei die wenigstens eine elektrische Antriebsvorrichtung (6), vorzugsweise ein Träger (22) zur Anbindung der wenigstens einen elektrischen Antriebsvorrichtung (6) an der wenigstens einen Korpusschiene (4), im Zuge einer relativen Bewegung zwischen der wenigstens einen Ladenschiene (5) und der wenigstens einen Korpusschiene (4) zumindest bereichsweise von der wenigstens eine Zahnstange (9) und/oder der wenigstens einen Lagervorrichtung (21) überfahrbar ist.

8. Anordnung nach einem der vorangehenden Ansprüche, wobei das bewegbare Möbelteil (2) in Gebrauchsstellung (14) der Anordnung eine Möbelteilfront (23) umfasst und die wenigstens eine elektrische Antriebsvorrichtung (6) an der wenigstens einen Korpusschiene (4) im Bereich eines der Möbelteilfront (23) zugewandten freien Endes (24) der Korpusschiene (4), vorzugsweise im Wesentlichen bündig zu dem freien Ende (24), angeordnet ist.

9. Anordnung nach einem der vorangehenden Ansprüche, wobei die wenigstens eine Zahnstange (9) eine Kopplungseinrichtung (25) umfasst, mit welcher die wenigstens eine Zahnstange (9) durch wenigstens eine Zahnstangenverlängerung (26) verlängerbar ist, wobei vorzugsweise vorgesehen ist, dass die wenigstens eine Zahnstange (9) in Längsrichtung (27) aus zumindest zwei Zahnstangensegmenten (28) zusammengesetzt ist.

10. Anordnung nach einem der vorangehenden Ansprüche, wobei die Anordnung, vorzugsweise die wenigstens eine elektrische Antriebsvorrichtung (6), wenigstens eine Freilaufkupplung (29) umfasst, mit welcher das bewegbare Möbelteil (2) in Schließrichtung und/oder in Öffnungsrichtung, vorzugsweise in Abhängigkeit einer Geschwindigkeit des bewegbaren Möbelteiles (2) und/oder einer Position des bewegbaren Möbelteiles (2), entlang der Wegstrecke (13) von einem Antrieb über den Elektromotor (7) entkoppelbar ist, wobei vorzugsweise vorgesehen ist, dass das bewegbare Möbelteil (2) zwischen einer Öffnungsstellung (30) und einer Schließstellung, besonders bevorzugt in Abhängigkeit einer Kraftausübung auf das bewegbare Möbelteil (2), in einem Feilaufbereich entkoppelt von einem Antrieb durch die wenigstens eine elektrische Antriebsvorrichtung (6) bewegbar ist und/oder über die Wegstrecke (13) durch die wenigstens eine elektrische Antriebsvorrichtung (6) antreibbar ist.

11. Anordnung nach einem der vorangehenden Ansprüche, wobei wenigstens ein, insbesondere gegenüber dem feststehenden Möbelteil (1) stationäres, Beleuchtungsmittel (31) vorgesehen ist, wobei das wenigstens eine Beleuchtungsmittel (31) an der wenigstens einen elektrischen Antriebsvorrichtung (6) und/oder an einer Stromleitung (32) der wenigstens einen elektrischen Antriebsvorrichtung (6) angeordnet ist.

12. Anordnung nach einem der vorangehenden Ansprüche, wobei wenigstens eine Wegmesseinrichtung (33) zur Bestimmung einer Position des bewegbaren Möbelteiles (2) relativ zu dem feststehenden Möbelteil (1) vorgesehen ist, wobei die Position in Form eines zurückgelegten Absolutweges des bewegbaren Möbelteiles (2) gegenüber dem feststehenden (1) Möbelteiles durch die wenigstens eine Wegmesseinrichtung (33), vorzugsweise eindeutig, ermittelbar ist.

13. Anordnung nach einem der vorangehenden Ansprüche, wobei die Führungsvorrichtung (3) wenigstens eine an dem feststehenden Möbelteil (1) angeordnete Korpusschiene (4) und wenigstens eine an dem bewegbaren Möbelteil (2) angeordnete Ladenschiene (5) umfasst, wobei die wenigstens eine Ladenschiene (5) wenigstens eine erste Schnittstelle (34) umfasst, welche dazu geeignet ist, eine Ausstoßeinrichtung (11) und/oder die Zuzieheinrichtung (8) an der wenigstens einen Ladenschiene (5) zu fixieren, und die wenigstens eine Korpusschiene (4) wenigstens eine zweite Schnittstelle (35) umfasst, welche dazu geeignet ist, einen Mitnehmer (36) für die Ausstoßeinrichtung (11) und/oder die Zuzieheinrichtung (8) an der wenigstens einen Korpusschiene (4) zu fixieren, wobei die wenigstens eine elektrische Antriebsvorrichtung (6) an der wenigstens einen zweiten Schnittstelle (35) angeordnet oder anordenbar ist und die wenigstens eine Zahnstange (9) zur Kraftübertragung von der wenigstens einen elektrischen Antriebsvorrichtung (6) auf die wenigstens eine Ladenschiene (5) an der wenigstens einen ersten Schnittstelle (34) angeordnet oder anordenbar ist.

14. Anordnung nach einem der vorangehenden Ansprüche, wobei die wenigstens eine elektrische Antriebsvorrichtung (6) in Gebrauchsstellung (14) der Anordnung im Wesentlichen vollständig unterhalb des bewegbaren Möbelteiles (2) an der wenigstens einen Korpusschiene (4) angeordnet ist.

15. Anordnung nach einem der vorangehenden Ansprüche, wobei die wenigstens eine elektrische Antriebsvorrichtung (6) einen Mikrokontroller (37), umfassend eine Recheneinheit und eine in mit der Recheneinheit in Datenverbindung stehende oder bringbare Speichereinheit, aufweist, wobei durch den Mikrokontroller (37) in Abhängigkeit zumindest eines in der Speichereinheit hinterlegten statischen Datensatzes ein Modell des bewegbaren Möbelteiles (2) ermittelbar ist und/oder in Abhängigkeit wenigstens eines dynamischen Datensatzes eine prognostizierte Bewegungstrajektorie des bewegbaren Möbelteiles (2) entlang der Führungsvorrichtung (3) berechenbar ist.

## Claims

1. An assembly comprising
- a fixed furniture part (1), in particular a furniture body,
- a furniture part (2), in particular a drawer, which is movable relative to the fixed furniture part (1),
- a guide device (3), in particular a drawer pull-out guide, for guiding the movable furniture part (2) relative to the fixed furniture part (1), with at least one body rail (4) and at least one drawer rail (5) displaceable relative to the at least one body rail (4), and
- at least one electric drive device (6) for at least partially automated movement of the movable furniture part (2) relative to the fixed furniture part (1), comprising an electric motor (7), in particular one which can be supplied with 230 V,
wherein at least one closing device (8) for the movable furniture part (2) and at least one toothed rack (9) operatively connected to the at least one electric drive device (6) are provided, wherein the at least one closing device (8) is arranged, preferably directly, on the at least one drawer rail (5), and the at least one toothed rack (9) is arranged, preferably indirectly, on the at least one drawer rail (5), and the at least one toothed rack (9) is arranged, preferably directly, on the at least one drawer rail (5), **characterized in that** the at least one toothed rack (9) is detachably arranged on at least one support device (10), and/or the at least one support device (10) for the toothed rack (9) is detachably arranged on the at least one closing device (8).

2. The assembly according to claim 1, wherein
- the at least one, preferably exactly one support device (10) is arranged at least in regions between the at least one toothed rack (9) and the at least one closing device (8), and/or
- the at least one support device (10) and/or the at least one closing device (8) comprises at least one, preferably mechanical, ejection device (11) and/or at least one damping device (12).

3. The assembly according to any one of the preceding claims, wherein
- the at least one electric drive device (6) is arranged in a stationary manner on the at least one body rail (4) and is in constant connection to the at least one toothed rack (9) for transmitting movement over an entire path (13) for the movable furniture part (2) along the guide device (3), wherein it is preferably provided that the electric drive device (6) comprises a gear wheel (17) which meshes with the at least one toothed rack (9), particularly preferably in the use position (14) of the assembly pointing upwards in the vertical direction (15) or in the horizontal direction (16) in the direction of the at least one drawer rail (5), and/or
- the at least one toothed rack (9) is arranged at least in regions between the at least one electric drive device (6) and the at least one drawer rail (5).

4. The assembly according to any one of the preceding claims, wherein the guide device (3) for moving the movable furniture part (2) comprises two drawer rails (5) arranged on two body rails (4), wherein exactly one electric drive device (6) is arranged on one of the two body rails (4) and/or exactly one toothed rack (9) is arranged on one of the two drawer rails (5).

5. The assembly according to any one of the preceding claims, wherein a power supply of the at least one electric drive device (6) or of a possibly present additional current sink is guided via the at least one body rail (4) and/or via the at least one toothed rack (9), preferably with a power connection between two body rails (4) and/or two toothed racks (9).

6. The assembly according to any one of the preceding claims, wherein a toothing (18) of the at least one toothed rack (9) in the use position (14) of the assembly is oriented downwards in the vertical direction (15) or in the horizontal direction (16) in a direction pointing away from the at least one drawer rail (5), wherein it is preferably provided that the at least one toothed rack (9) is coupled to a gear wheel (17) of the at least one electric drive device (6), wherein
- the at least one toothed rack (9) with a vertically aligned toothing (18) is mounted in the horizontal direction (16) and/or in the vertical direction (15) in the direction of the at least one drawer rail (5), particularly preferably relative to the at least one support device (10), so as to be pivotable or bendable about an imaginary axis and thus to be laterally and/or vertically movable to a limited extent, or
- the at least one toothed rack (9) with a vertically aligned toothing (18) is mounted in the vertical direction (15) downward and/or in the horizontal direction (16), particularly preferably relative to the at least one support device (10), so as to be pivotable or bendable about an imaginary axis and thus to be laterally and/or vertically movable to a limited extent.

7. The assembly according to any one of the preceding claims, wherein
- the guide device (3) comprises two body rails (4) and two drawer rails (5) which are displaceable relative to the body rails (4), wherein two additional toothed racks (19) are provided which are arranged on the two body rails (4) and/or the two drawer rails (5), wherein a synchronization rod (20) is arranged between the two additional toothed racks (19) for lateral stabilization on the two additional toothed racks (19), and/or
- at least one bearing device (21) for the at least one toothed rack (9) is arranged on the at least one drawer rail (5) and the at least one toothed rack (9), wherein the at least one electric drive device (6), preferably a support (22) for connecting the at least one electric drive device (6) to the at least one body rail (4), can be traversed at least in regions by the at least one toothed rack (9) and/or the at least one bearing device (21) during a relative movement between the at least one drawer rail (5) and the at least one body rail (4).

8. The assembly according to any one of the preceding claims, wherein the movable furniture part (2) in the use position (14) of the assembly comprises a furniture part front (23), and the at least one electric drive device (6) is arranged on the at least one body rail (4) in the region of a free end (24) of the body rail (4) facing the furniture part front (23), preferably substantially flush with the free end (24).

9. The assembly according to any one of the preceding claims, wherein the at least one toothed rack (9) comprises a coupling device (25) with which the at least one toothed rack (9) can be extended by at least one toothed rack extension (26), wherein it is preferably provided that the at least one toothed rack (9) is composed of at least two toothed rack segments (28) in the longitudinal direction (27).

10. The assembly according to any one of the preceding claims, wherein the assembly, preferably the at least one electric drive device (6), comprises at least one one-way clutch (29) with which the movable furniture part (2) can be decoupled from a drive via the electric motor (7) in the closing direction and/or in the opening direction, preferably according to a speed of the movable furniture part (2) and/or a position of the movable furniture part (2), along the path (13), wherein it is preferably provided that the movable furniture part (2) can be moved between an open position (30) and a closed position, particularly preferably according to a force exerted on the movable furniture part (2), in a free-run area decoupled from a drive by the at least one electric drive device (6) and/or can be driven over the path (13) by the at least one electric drive device (6).

11. The assembly according to any one of the preceding claims, wherein at least one lighting means (31) is provided, in particular stationary relative to the fixed furniture part (1), wherein the at least one lighting means (31) is arranged on the at least one electric drive device (6) and/or on a power line (32) of the at least one electric drive device (6).

12. The assembly according to any one of the preceding claims, wherein at least one path measuring device (33) is provided for determining a position of the movable furniture part (2) relative to the fixed furniture part (1), wherein the position can be determined, preferably unambiguously, in the form of an absolute path traveled by the movable furniture part (2) relative to the fixed (1) furniture part by the at least one path measuring device (33).

13. The assembly according to any one of the preceding claims, wherein the guide device (3) comprises at least one body rail (4) arranged on the fixed furniture part (1) and at least one drawer rail (5) arranged on the movable furniture part (2), wherein the at least one drawer rail (5) comprises at least one first intersection (34) which is suitable for fixing an ejection device (11) and/or the closing device (8) to the at least one drawer rail (5), and the at least one body rail (4) comprises at least one second intersection (35) which is suitable for fixing a carrier (36) for the ejection device (11) and/or the closing device (8) to the at least one body rail (4), wherein the at least one electric drive device (6) is arranged or can be arranged on the at least one second intersection (35), and the at least one toothed rack (9) for transmitting power from the at least one electric drive device (6) to the at least one drawer rail (5) is arranged or can be arranged on the at least one first intersection (34).

14. The assembly according to any one of the preceding claims, wherein the at least one electric drive device (6) is arranged in the use position (14) of the assembly substantially completely below the movable furniture part (2) on the at least one body rail (4).

15. The assembly according to any one of the preceding claims, wherein the at least one electric drive device (6) has a microcontroller (37)comprising a computing unit and a memory unit which is or can be connected to the computing unit in data connection, wherein a model of the movable furniture part (2) can be determined by the microcontroller (37) according to at least one static data set stored in the memory unit, and/or a predicted movement trajectory of the movable furniture part (2) along the guide device (3) can be calculated according to at least one dynamic data set.

## Revendications

1. Dispositif comprenant
- une partie de meuble fixe (1), notamment un corps de meuble,
- une partie de meuble mobile (2), notamment un tiroir, déplaçable par rapport à la partie de meuble fixe (1),
- un dispositif de guidage (3), notamment un guide de sortie de tiroir, pour le guidage de la partie de meuble mobile (2) par rapport à la partie de meuble fixe (1), et comprenant au moins un rail de corps (4) et au moins un rail de tiroir (5) déplaçable par rapport audit au moins un rail de corps (4), et
- au moins un dispositif d'entraînement électrique (6) pour le mouvement automatisé, au moins sur une portion, de la partie de meuble mobile (2) par rapport à la partie de meuble fixe (1), comprenant un moteur électrique (7), pouvant notamment être alimenté en 230 V,
au moins un dispositif de rappel (8) pour la partie de meuble mobile (2) et au moins une crémaillère (9) en liaison fonctionnelle avec ledit au moins un dispositif d'entraînement électrique (6) étant prévus,
ledit au moins un dispositif de rappel (8) étant disposé, de préférence directement, sur ledit au moins un rail de tiroir (5) et ladite au moins une crémaillère (9) étant disposée, de préférence indirectement, sur ledit au moins un rail de tiroir (5),
**caractérisé en ce que** ladite au moins une crémaillère (9) est disposée de manière amovible sur au moins un dispositif de support (10) et/ou qu'au moins un dispositif de support (10) pour la crémaillère (9) est disposé de manière amovible sur ledit au moins un dispositif de rappel (8).

2. Dispositif selon la revendication 1, dans lequel ledit
- ledit au moins un dispositif de support (10), de préférence ledit exactement un dispositif de support, est disposé au moins en partie entre ladite au moins une crémaillère (9) et ledit au moins un dispositif de rappel (8) et/ou
- ledit au moins un dispositif de support (10) et/ou ledit au moins un dispositif de rappel (8) comprennent au moins un dispositif d'éjection (11), de préférence mécanique, et/ou au moins un dispositif d'amortissement (12).

3. Dispositif selon l'une des revendications précédentes, dans lequel
- ledit au moins un dispositif d'entraînement électrique (6) est disposé de manière stationnaire sur ledit au moins un rail de corps (4) et est en liaison continue avec ladite au moins une crémaillère (9) pour la transmission de mouvement sur un trajet (13) complet de la partie de meuble mobile (2) le long du dispositif de guidage (3), étant de préférence prévu que le dispositif d'entraînement électrique (6) comprenne une roue dentée (17) s'engrenant avec ladite au moins une crémaillère (9), particulièrement de préférence orientée, en position d'utilisation (14) du dispositif, en direction verticale (15) vers le haut ou en direction horizontale (16) vers ledit au moins un rail de tiroir (5), et/ou
- ladite au moins une crémaillère (9) est disposée au moins en partie entre ledit au moins un dispositif d'entraînement électrique (6) et ledit au moins un rail de tiroir (5).

4. Dispositif selon l'une des revendications précédentes, dans lequel le dispositif de guidage (3) pour le mouvement de la partie de meuble mobile (2) comprend deux rails de tiroir (5) disposés sur deux rails de corps (4), exactement une unité d'entraînement électrique (6) étant disposée sur l'un des deux rails de corps (4) et/ou exactement une crémaillère (9) étant disposée sur l'un des deux rails de tiroir (5).

5. Dispositif selon l'une des revendications précédentes, dans lequel une alimentation électrique dudit au moins un dispositif d'entraînement électrique (6) ou d'un autre consommateur de courant éventuellement présent est réalisée via ledit au moins un rail de corps (4) et/ou via ladite au moins une crémaillère (9), de préférence avec une liaison électrique entre deux rails de corps (4) et/ou deux crémaillères (9).

6. Dispositif selon l'une des revendications précédentes, dans lequel une denture (18) de ladite au moins une crémaillère (9) est orientée, en position d'utilisation (14), en direction verticale (15) vers le bas ou en direction horizontale (16) dans une direction opposée audit au moins un rail de tiroir (5), étant de préférence prévu que ladite au moins une crémaillère (9) soit couplée à une roue dentée (17) dudit au moins un dispositif d'entraînement électrique (6),
- ladite au moins une crémaillère (9), en cas de denture (18) orientée verticalement, étant montée de manière pivotable ou déformable autour d'un axe imaginaire en direction horizontale (16) et/ou en direction verticale (15) vers ledit au moins un rail de tiroir (5), particulièrement de préférence par rapport audit au moins un dispositif de support (10), et étant ainsi montée de manière mobile latéralement et/ou verticalement de façon limitée, ou
- ladite au moins une crémaillère (9), en cas de denture (18) orientée horizontalement, étant montée de manière pivotable ou déformable autour d'un axe imaginaire en direction verticale (15) vers le bas et/ou en direction horizontale (16), particulièrement de préférence par rapport audit au moins un dispositif de support (10), et étant ainsi montée de manière mobile verticalement et/ou latéralement de façon limitée.

7. Dispositif selon l'une des revendications précédentes, dans lequel
- le dispositif de guidage (3) comprend deux rails de corps (4) et deux rails de tiroir (5) déplaçables par rapport aux rails de corps (4), deux crémaillères supplémentaires (19) étant prévues, lesquelles sont disposées sur les deux rails de corps (4) et/ou les deux rails de tiroir (5), une barre de synchronisation (20) étant disposée sur les deux crémaillères supplémentaires (19) entre lesdites deux crémaillères supplémentaires (19) pour la stabilisation latérale, et/ou
- au moins un dispositif de palier (21) pour ladite au moins une crémaillère (9) est disposé sur ledit au moins un rail de tiroir (5) et sur ladite au moins une crémaillère (9), ladite au moins une crémaillère (9) et/ou ledit au moins un dispositif de palier (21), lors d'un mouvement relatif entre ledit au moins un rail de tiroir (5) et ledit au moins un rail de corps (4), pouvant passer au-dessus d'au moins une portion dudit au moins un dispositif d'entraînement électrique (6), de préférence un support (22) pour la fixation dudit au moins un dispositif d'entraînement électrique (6) sur ledit au moins un rail de corps (4).

8. Dispositif selon l'une des revendications précédentes, dans lequel la partie de meuble mobile (2) comprend, en position d'utilisation (14) du dispositif, une façade de meuble (23), et ledit au moins un dispositif d'entraînement électrique (6) est disposé sur ledit au moins un rail de corps (4) au niveau d'une extrémité libre (24) du rail de corps (4) tournée vers la façade de meuble (23), de préférence en affleurant sensiblement ladite extrémité libre (24).

9. Dispositif selon l'une des revendications précédentes, dans lequel ladite au moins une crémaillère (9) comprend un dispositif d'accouplement (25) par lequel ladite au moins une crémaillère (9) peut être prolongée par au moins une extension de crémaillère (26), étant de préférence prévu que ladite au moins une crémaillère (9) soit composée, dans la direction longitudinale (27), d'au moins deux segments de crémaillère (28).

10. Dispositif selon l'une des revendications précédentes, dans lequel le dispositif, de préférence ledit au moins un dispositif d'entraînement électrique (6), comprend au moins un embrayage à roue libre (29) par lequel la partie de meuble mobile (2) peut être désaccouplée d'un entraînement par le moteur électrique (7) dans le sens de fermeture et/ou dans le sens d'ouverture, de préférence en fonction d'une vitesse de la partie de meuble mobile (2) et/ou d'une position de la partie de meuble mobile (2) le long du trajet (13), étant de préférence prévu que la partie de meuble mobile (2), entre une position d'ouverture (30) et une position de fermeture, particulièrement de préférence en fonction d'une application de force sur la partie de meuble mobile (2), soit mobile dans une zone de libre mouvement en étant désaccouplée d'un entraînement par ledit au moins un dispositif d'entraînement électrique (6) et/ou puisse être entraînée sur le trajet (13) par ledit au moins un dispositif d'entraînement électrique (6).

11. Dispositif selon l'une des revendications précédentes, dans lequel il est prévu au moins un moyen d'éclairage (31), notamment stationnaire par rapport à la partie de meuble fixe (1), ledit au moins un moyen d'éclairage (31) étant disposé sur ledit au moins un dispositif d'entraînement électrique (6) et/ou sur un câble d'alimentation électrique (32) dudit au moins un dispositif d'entraînement électrique (6).

12. Dispositif selon l'une des revendications précédentes, dans lequel il est prévu au moins un dispositif de mesure de déplacement (33) pour déterminer une position de la partie de meuble mobile (2) par rapport à la partie de meuble fixe (1), la position pouvant être déterminée au moyen dudit au moins un dispositif de mesure de déplacement (33), de préférence de manière univoque, sous la forme d'un déplacement absolu parcouru par la partie de meuble mobile (2) par rapport à la partie de meuble fixe (1).

13. Dispositif selon l'une des revendications précédentes, dans lequel le dispositif de guidage (3) comprend au moins un rail de corps (4) disposé sur la partie de meuble fixe (1) et au moins un rail de tiroir (5) disposé sur la partie de meuble mobile (2), ledit au moins un rail de tiroir (5) comprenant au moins une première interface (34) adaptée pour fixer un dispositif d'éjection (11) et/ou le dispositif de rappel (8) sur ledit au moins un rail de tiroir (5), et ledit au moins un rail de corps (4) comprenant au moins une deuxième interface (35) adaptée pour fixer un entraîneur (36) pour le dispositif d'éjection (11) et/ou le dispositif de rappel (8) sur ledit au moins un rail de corps (4), ledit au moins un dispositif d'entraînement électrique (6) étant disposé ou disposable sur ladite au moins une deuxième interface (35), et ladite au moins une crémaillère (9) étant disposée ou disposable sur ladite au moins une première interface (34) pour la transmission de force dudit au moins un dispositif d'entraînement électrique (6) audit au moins un rail de tiroir (5).

14. Dispositif selon l'une des revendications précédentes, dans lequel, en position d'utilisation (14) du dispositif, ledit au moins un dispositif d'entraînement électrique (6) est disposé sur ledit au moins un rail de corps (4) pour l'essentiel entièrement au-dessous de la partie de meuble mobile (2).

15. Dispositif selon l'une des revendications précédentes, dans lequel ledit au moins un dispositif d'entraînement électrique (6) comprend un microcontrôleur (37) comprenant une unité de calcul et une unité de mémoire en liaison de données avec l'unité de calcul, ou susceptible d'être mise en liaison de données avec celle-ci, un modèle de la partie de meuble mobile (2) pouvant être déterminé par le microcontrôleur (37) en fonction d'au moins un jeu de données statiques enregistré dans l'unité de mémoire et/ou une trajectoire de mouvement prévisionnelle de la partie de meuble mobile (2) le long du dispositif de guidage (3) pouvant être calculée en fonction d'au moins un jeu de données dynamiques.
